# EUROPEAN PATENT APPLICATION

(11) **EP 4 436 330 A2**
(43) Date of publication of application: **25.09.2024**
(21) Application number: 24164401.2
(22) Date of filing: 19.03.2024
(51) Int. Cl.: H10B 12/00

(54) **SEMICONDUCTOR DEVICE AND METHOD OF MANUFACTURING THE SAME**

(30) Priority: 24.03.2023 KR 20230039035; 24.04.2023 KR 20230053387
(71) Applicant: Samsung Electronics Co., Ltd., Suwon-si, Gyeonggi-do 16677 (KR)
(72) Inventor: WON, Seokjae, 16677 Suwon-si (KR); KANG, Yoongoo, 16677 Suwon-si (KR); PARK, Jaehong, 16677 Suwon-si (KR)
(74) Representative: Marks & Clerk LLP

(57) **Abstract**

The present disclosure provides semiconductor devices including a bit line. In some embodiments, a semiconductor device includes a substrate including a plurality of active regions defined by device isolation layers, a plurality of bit lines extending in a first horizontal direction on the substrate, a bit line contact between a first active region of the plurality of active regions and a first bit line of the plurality of bit lines on the first active region, and an active pad on a second active region of the plurality of active regions adjacent to the first active region. The bit line contact includes a first contact layer and a second contact layer on the first contact layer. The active pad is disposed to face the bit line contact.

## Description

### BACKGROUND

### Field

The present disclosure relates generally to a semiconductor device and a manufacturing method thereof, and more particularly, to a semiconductor device including a bit line and a manufacturing method thereof.

### Description of Related Art

As a related semiconductor device is downscaled, the size of individual fine circuit patterns for implementing the related semiconductor device may be further reduced. Alternatively or additionally, as integrated circuit devices may be relatively highly integrated, the line width of bit lines may decrease, and as such, the difficulty of a process of forming contacts between bit lines may increase.

### SUMMARY

Aspects of the present disclosure provide for a semiconductor device capable of potentially reducing a difficulty of a process of forming a contact between bit lines.

According to an aspect of the present disclosure, a semiconductor device is provided. The semiconductor device includes a substrate including a plurality of active regions defined by device isolation layers, a plurality of bit lines extending in a first horizontal direction on the substrate, a bit line contact between a first active region of the plurality of active regions and a first bit line of the plurality of bit lines on the first active region, and an active pad on a second active region of the plurality of active regions adjacent to the first active region. The bit line contact includes a first contact layer and a second contact layer on the first contact layer, the active pad is disposed to face the bit line contact.

According to an aspect of the present disclosure, a semiconductor device is provided. The semiconductor device includes a substrate including a plurality of active regions defined by device isolation layers, a plurality of bit lines extending in a first horizontal direction on the substrate, a bit line contact between a first active region of the plurality of active regions and a first bit line of the plurality of bit lines on the first active region, a bit line contact spacer surrounding at least a first portion of the bit line contact, and an active pad disposed in an active pad hole extending into a second active region of the plurality of active regions adjacent to the first active region. The bit line contact includes a first contact layer and a second contact layer on the first contact layer. The active pad surrounds at least a second portion of the bit line contact spacer.

According to an aspect of the present disclosure, a semiconductor device is provided. The semiconductor device includes a substrate including a plurality of active regions defined by device isolation layers, a plurality of bit lines extending in a first horizontal direction on the substrate, a bit line contact between a first active region of the plurality of active regions and a first bit line of the plurality of bit lines on the first active region, a bit line contact spacer surrounding at least a first portion of the bit line contact, an active pad disposed in an active pad hole extending into a second active region of the plurality of active regions adjacent to the first active region, and a buried contact on the active pad. The bit line contact includes a first contact layer and a second contact layer on the first contact layer. The bit line contact spacer includes a first contact spacer layer surrounding at least a second portion of a first sidewall of the first contact layer and a second contact spacer layer disposed on an inner wall of the first contact spacer layer and surrounding at least a third portion of a second sidewall of the second contact layer. The active pad surrounds at least a portion of the bit line contact spacer.

Additional aspects may be set forth in part in the description which follows and, in part, may be apparent from the description, and/or may be learned by practice of the presented embodiments.

At least some of the above and other features of the invention are set out in the claims.

### BRIEF DESCRIPTION OF THE DRAWINGS

The above and other aspects, features, and advantages of certain embodiments of the present disclosure may be more apparent from the following detailed description taken in conjunction with the accompanying drawings, in which:
FIG. 1 is a layout diagram illustrating a semiconductor device, according to various embodiments;
FIG. 2 is an enlarged layout diagram of a portion II of FIG. 1, according to various embodiments;
FIG. 3 is a cross-sectional view taken along line A-A' of FIG. 2, according to various embodiments;
FIG. 4 is a cross-sectional view taken along line B-B' of FIG. 2, according to various embodiments;
FIG. 5 is an enlarged view of a portion CX1 of FIG. 3, according to various embodiments;
FIG. 6 is a horizontal cross-sectional view at a reference level LV0 of FIG. 3, according to various embodiments;
FIG. 7 is a cross-sectional view illustrating a semiconductor device, according to various embodiments;
FIG. 8 is an enlarged view of a portion CX1 of FIG. 7, according to various embodiments;
FIG. 9 is a cross-sectional view illustrating a semiconductor device, according to various embodiments;
FIG. 10 is an enlarged view of a portion CX1 of FIG. 9, according to various embodiments;
FIG. 11 is a cross-sectional view illustrating a semiconductor device, according to various embodiments;
FIG. 12 is a cross-sectional view illustrating a semiconductor device, according to various embodiments;
FIG. 13 is a cross-sectional view illustrating a semiconductor device, according to various embodiments;
FIGS. 14A to 24C are cross-sectional views illustrating a method of manufacturing a semiconductor device, according to various embodiments;
FIGS. 25 to 27 are cross-sectional views illustrating a method of manufacturing a semiconductor device, according to various embodiments; and
FIGS. 28A to 30 are cross-sectional views illustrating a method of manufacturing a semiconductor device, according to various embodiments.

### DETAILED DESCRIPTION

The following description with reference to the accompanying drawings is provided to assist in a comprehensive understanding of embodiments of the present disclosure defined by the claims and their equivalents. Various specific details are included to assist in understanding, but these details are considered to be examples only. Therefore, those of ordinary skill in the art may recognize that various changes and modifications of the embodiments described herein may be made without departing from the scope of the disclosure. In addition, descriptions of well-known functions and structures are omitted for clarity and conciseness.

With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wired), wirelessly, or via a third element.

It is to be understood that when an element or layer is referred to as being "over," "above," "on," "below," "under," "beneath," "connected to" or "coupled to" another element or layer, it may be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

The terms "upper," "middle", "lower", and the like may be replaced with terms, such as "first," "second," third" to be used to describe relative positions of elements. The terms "first," "second," third" may be used to describe various elements but the elements are not limited by the terms and a "first element" may be referred to as a "second element". Alternatively or additionally, the terms "first", "second", "third", and the like may be used to distinguish components from each other and do not limit the present disclosure. For example, the terms "first", "second", "third", and the like may not necessarily involve an order or a numerical meaning of any form.

Reference throughout the present disclosure to "one embodiment," "an embodiment," "an example embodiment," or similar language may indicate that a particular feature, structure, or characteristic described in connection with the indicated embodiment is included in at least one embodiment of the present solution. Thus, the phrases "in one embodiment", "in an embodiment," "in an example embodiment," and similar language throughout this disclosure may, but do not necessarily, all refer to the same embodiment.

The embodiments herein may be described and illustrated in terms of blocks, as shown in the drawings, which carry out a described function or functions. These blocks, which may be referred to herein as units or modules or the like, or by names such as device, logic, circuit, counter, comparator, generator, converter, or the like, may be physically implemented by analog and/or digital circuits including one or more of a logic gate, an integrated circuit, a microprocessor, a microcontroller, a memory circuit, a passive electronic component, an active electronic component, an optical component, and the like, and may also be implemented by or driven by software and/or firmware (configured to perform the functions or operations described herein).

As used herein, each of the terms "Co", "CoSi", "GaAs", "InAs", "InP", "Mo", "NiSi", "Ru", "SiC", "SiGe", "SiN", "SiO", "SiON", "Ta", "TaN", "Ti", "TiN", "TiSiN", "W", "WN", "WSi", "WSiN", and the like may refer to a material made of elements included in each of the terms and is not a chemical formula representing a stoichiometric relationship.

Hereinafter, various embodiments of the present disclosure are described with reference to the accompanying drawings.

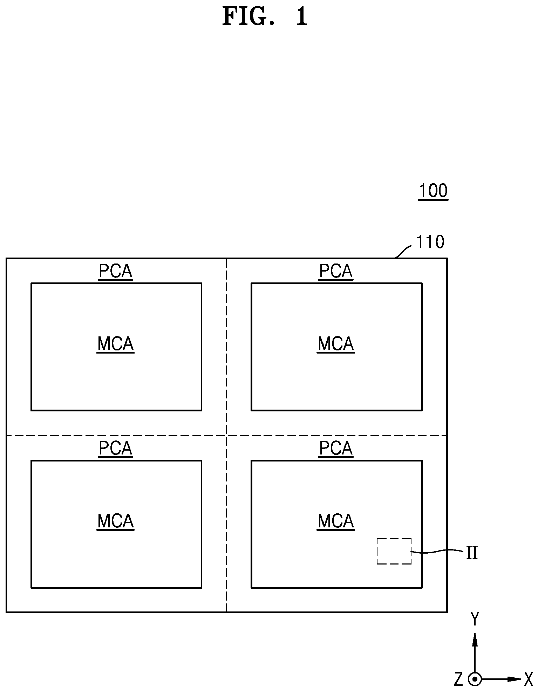

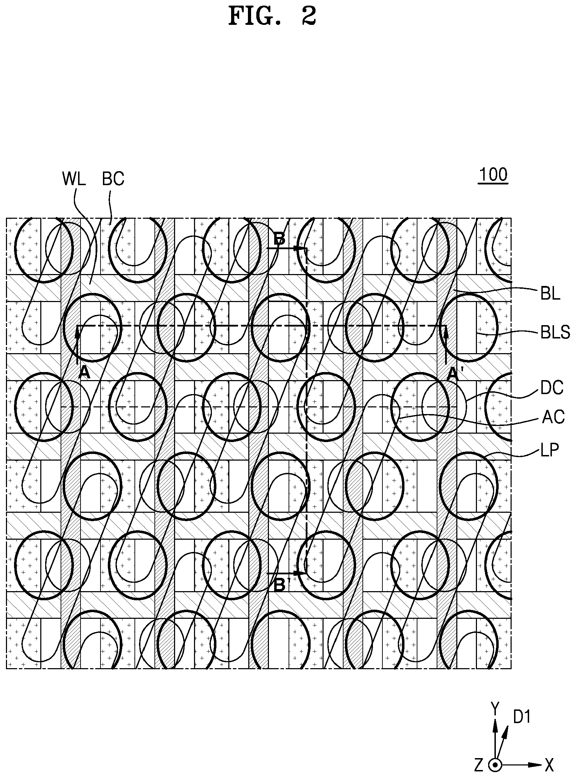

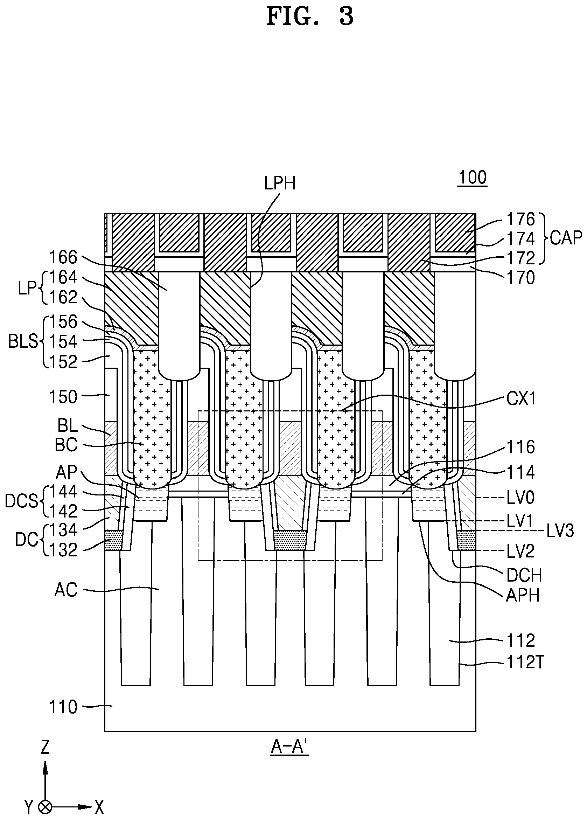

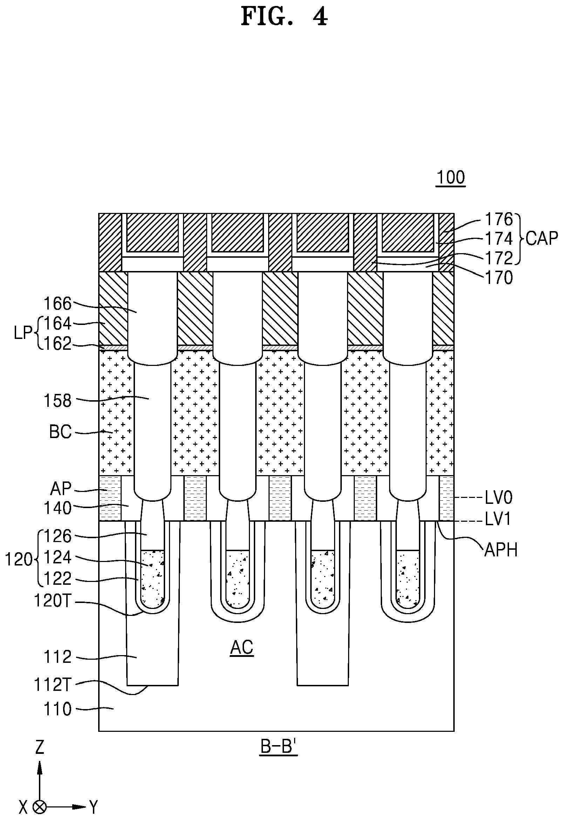

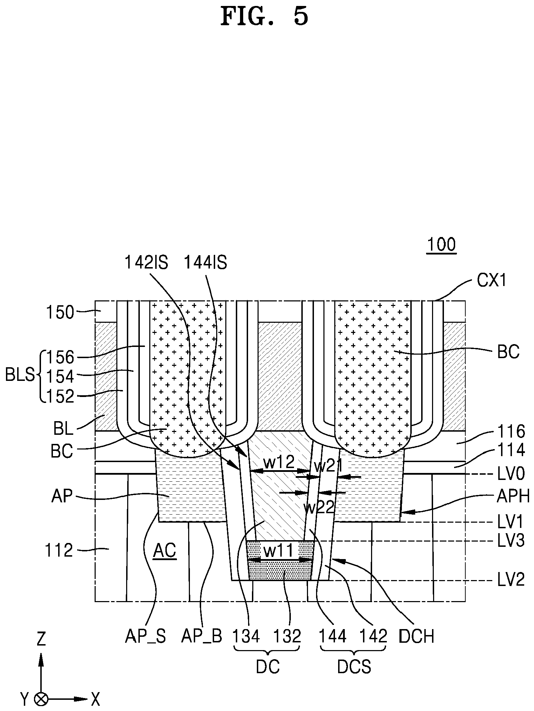

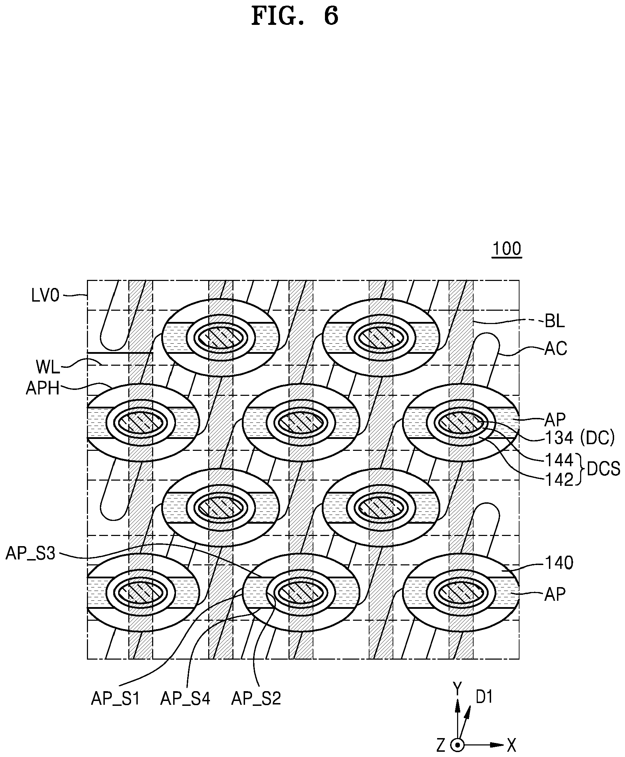

FIG. 1 is a layout diagram illustrating a semiconductor device 100, according to various embodiments. FIG. 2 is an enlarged layout diagram of a portion II of FIG. 1, according to various embodiments. FIG. 3 is a cross-sectional view taken along line A-A' of FIG. 2, according to various embodiments. FIG. 4 is a cross-sectional view taken along line B-B' of FIG. 2, according to various embodiments. FIG. 5 is an enlarged view of a portion CX1 of FIG. 3, according to various embodiments. FIG. 6 is a horizontal cross-sectional view at a reference level LV0 of FIG. 3, according to various embodiments.

Referring to FIGS. 1 to 6, the semiconductor device 100 may include a substrate 110. The substrate 110 may include a cell array area MCA and a peripheral circuit area PCA. The cell array area MCA may be and/or may include a memory cell area of a dynamic random-access memory (DRAM) device. Alternatively or additionally, the peripheral circuit area PCA may be and/or may include a core area and/or a peripheral circuit area of the DRAM device. For example, the cell array area MCA may include a cell transistor CTR (not shown) and/or a capacitor structure CAP connected thereto. As another example, the peripheral circuit area PCA may include peripheral circuit transistors (not shown) for transmitting signals and/or power to the cell transistors CTR included in the cell array area MCA. In some embodiments, the peripheral circuit transistor may be configured to include various circuits such as, but not limited to, a command decoder, control logic, an address buffer, a row decoder, a column decoder, a sense amplifier, a data input/output circuit, and the like.

In an embodiment, a device isolation trench 112T may be formed in the substrate 110. Alternatively or additionally, a device isolation layer 112 may be formed in the device isolation trench 112T. In an optional or additional embodiment, a plurality of active regions AC may be defined on the substrate 110 by the device isolation layer 112.

As shown in FIG. 2, the plurality of active regions AC may be arranged to have long axes in a first oblique direction D1 inclined with respect to the first horizontal direction X and the second horizontal direction Y, respectively. A plurality of word lines WL may extend parallel to each other in the first horizontal direction X across the plurality of active regions AC. A plurality of bit lines BL may extend parallel to each other in the second horizontal direction Y on the plurality of word lines WL. The plurality of bit lines BL may be respectively connected to the plurality of active regions AC through bit line contacts DC.

A plurality of buried contacts BC may be formed between two adjacent bit lines BL among the plurality of bit lines BL. A plurality of landing pads LP may be formed on the plurality of buried contacts BC. The plurality of buried contacts BC and the plurality of landing pads LP may connect a lower electrode 172 of a capacitor structure CAP formed on the plurality of bit lines BL to an active region AC. Each of the plurality of landing pads LP may be disposed to overlap a portion of the buried contact BC and/or a portion of the bit line BL.

The substrate 110 may include silicon (Si), for example, monocrystalline silicon, polycrystalline silicon, or amorphous silicon. In some embodiments, the substrate 110 may include, but not be limited to, at least one of germanium (Ge), silicon-germanium (SiGe), silicon carbide (SiC), gallium arsenide (GaAs), indium arsenide (InAs), and indium phosphide (InP). In some embodiments, the substrate 110 may include a conductive region, for example, a well doped with impurities and/or a structure doped with impurities.

The device isolation layer 112 may include an oxide layer, a nitride layer, and/or a combination thereof. A first buffer insulating layer 114 and a second buffer insulating layer 116 may be sequentially disposed on the upper surface of the substrate 110. Each of the first buffer insulating layer 114 and the second buffer insulating layer 116 may include, but not be limited to, silicon oxide (SiO), silicon oxynitride (SiON), or silicon nitride (SiN).

A plurality of word line trenches 120T extending in a first horizontal direction X may be disposed on the substrate 110. Alternatively or additionally, a buried gate structure 120 may be disposed in the plurality of word line trenches 120T. The buried gate structure 120 may include a gate dielectric layer 122, a gate electrode 124, and a word line capping layer 126 disposed in each of the plurality of word line trenches 120T. The plurality of gate electrodes 124 may correspond to the plurality of word lines WL illustrated in FIG. 2.

The plurality of gate dielectric layers 122 may include, but not be limited to, a silicon oxide (SiO) layer, a silicon nitride (SiN) layer, a silicon oxynitride (SiON) layer, an oxide/nitride/oxide (ONO) layer, and/or a relatively high-k dielectric film having a higher dielectric constant than the silicon oxide (SiO) layer. In an embodiment, the plurality of gate electrodes 124 may include, but not be limited to, at least one of titanium (Ti), titanium nitride (TiN), tantalum (Ta), tantalum nitride (TaN), tungsten (W), tungsten nitride (WN), titanium silicium nitride (TiSiN), tungsten silicon nitride (WSiN), or a combination thereof. The plurality of word line capping layers 126 may include, but not be limited to, a silicon oxide (SiO) layer, a silicon nitride (SiN) layer, a silicon oxynitride (SiON) layer, or a combination thereof.

The plurality of bit line contact holes DCH may pass through the first buffer insulating layer 114 and the second buffer insulating layer 116 and extend into the substrate 110. Alternatively or additionally, a plurality of bit line contacts DC may be respectively formed in the plurality of bit line contact holes DCH. The plurality of bit line contacts DC may be respectively connected to the plurality of active regions AC. In one embodiment, a bit line contact may be between a first active region of the plurality of active regions and a first bit line of the plurality of bit lines on the first active region.

The plurality of bit line contacts DC may include a first contact layer 132 and a second contact layer 134. The first contact layer 132 may be disposed on the upper surface of the active region AC. Alternatively or additionally, the second contact layer 134 may be disposed on the upper surface of the first contact layer 132. The first contact layer 132 may have a first width w11 in the first horizontal direction X. The second contact layer 134 may have a second width w12 in the first horizontal direction X. In an embodiment, the second width w12 may be less (e.g., narrower) than the first width w11. Accordingly, a step may be formed on sidewalls of the plurality of bit line contacts DC. For example, the step may be formed at the boundary between the first contact layer 132 and the second contact layer 134. Alternatively or additionally, an edge portion of the upper surface of the first contact layer 132 may protrude outward from a sidewall of the second contact layer 134. In some embodiments, the first contact layer 132 and the second contact layer 134 may include at least one of titanium (Ti), titanium nitride (TiN), tantalum (Ta), tantalum nitride (TaN), ruthenium (Ru), cobalt (Co), molybdenum (Mo), tungsten (W), tungsten nitride (WN), titanium silicium nitride (TiSiN), tungsten silicon nitride (WSiN), cobalt silicide (CoSi), nickel silicide (NiSi), and tungsten silicide (WSi). In one embodiment, the first contact layer may have a first width in a second horizontal direction perpendicular to the first horizontal direction, the second contact layer may have a second width in the second horizontal direction, the second width being less than the first width.

The bit line contact spacer DCS may cover a sidewall of the bit line contact DC in a bit line contact hole DCH. In some embodiments, the bit line contact spacer DCS may include a first contact spacer layer 142 and a second contact spacer layer 144. The first contact spacer layer 142 may be formed on the inner wall of the bit line contact hole DCH and/or may have an annular shape in a plan view. The second contact spacer layer 144 may be disposed on the inner wall 142IS of the first contact spacer layer 142 and/or may have an annular shape in a plan view. The second contact spacer layer 144 may have a bottom surface disposed at a higher level than the bottom surface of the first contact spacer layer 142. The first contact spacer layer 142 and the second contact spacer layer 144 may include, but not be limited to, silicon nitride (SiN) and/or silicon oxynitride (SiON).

The first contact layer 132 of the bit line contact DC may be disposed to contact the lower side of the inner wall 142IS of the first contact spacer layer 142. Alternatively or additionally, the second contact layer 134 of the bit line contact DC may be disposed to contact an inner wall 144IS of the second contact spacer layer 144.

In various embodiments, an upper portion of the bit line contact spacer DCS may include a first contact spacer layer 142 and a second contact spacer layer 144. In such embodiments, since the lower portion of the bit line contact spacer DCS may only include the first contact spacer layer 142, the bit line contact spacer DCS may include a step on the inner wall thereof. The step formed in the bit line contact spacer DCS may be disposed at the same level as the boundary between the first contact layer 132 and the second contact layer 134 (e.g., the top surface of the first contact layer 132 and the bottom surface of the second contact layer 134). In one embodiment, the bit line contact spacer may surround at least a portion of the bit line contact. In one embodiment, the bit line contact spacer may comprise a first contact spacer layer on an inner wall of a bit line contact hole extending into the substrate, and a second contact spacer layer on an inner sidewall of the first contact spacer layer on the inner wall of the bit line contact hole. In one embodiment, a sidewall of the first contact layer may be at least partially surrounded by the first contact spacer layer, a bottom surface of the first contact layer may contact a top surface of the first active region, and the second contact layer may be at least partially surrounded by the second contact spacer layer on an upper surface of the first contact layer. In one embodiment, the first contact spacer layer may be on a first inner wall of a bit line contact hole extending into the substrate, and a second contact spacer layer may be on the first inner wall of the bit line contact hole and on a second inner wall of the first contact spacer layer.

In some embodiments, the plurality of bit line contacts DC may be formed in the bit line contact hole DCH in a damascene manner. For example, the first contact layer 132 may be formed on the lower side of the space surrounded by the inner wall 142IS of the first contact spacer layer 142. Subsequently, a second spacer layer 154 may be formed on the upper side of the inner wall 142IS of the first contact spacer layer 142. Alternatively or additionally, the second contact layer 134 may be formed in a space surrounded by the inner wall 144IS of the second contact spacer layer 144.

In some embodiments, the first contact spacer layer 142 may have a first thickness w21 in the first horizontal direction X. Alternatively or additionally, the second contact spacer layer 144 may have a second thickness w22 in the first horizontal direction X. In such embodiments, the second thickness w22 may be less than the first thickness w21. That is, the second thickness w22 of the second contact spacer layer 144 may be appropriately selected to adjust the width of the second contact layer 134. For example, as the second contact layer 134 fills the space surrounded by the inner wall 144IS of the second contact spacer layer 144 in the damascene manner, an etching process with high difficulty may be omitted. As another example, according to a related example process for forming the bit line contact, an etching process for forming a conductive layer in the bit line contact hole and removing a side portion of the conductive layer, to reduce the width of the conductive layer, may be omitted.

The plurality of bit lines BL may extend in the second horizontal direction Y on the substrate 110 and the plurality of bit line contacts DC. Each of the plurality of bit lines BL may be connected to the active region AC through a bit line contact DC. The plurality of bit lines BL may include, but not be limited to, at least one of polysilicon, titanium (Ti), titanium nitride (TiN), tantalum (Ta), tantalum nitride (TaN), ruthenium (Ru), cobalt (Co), molybdenum (Mo), tungsten (W), tungsten nitride (WN), titanium silicium nitride (TiSiN), tungsten silicon nitride (WSiN), cobalt silicide (CoSi), nickel silicide (NiSi), and tungsten silicide (WSi). In some embodiments, each of the plurality of bit lines BL may be formed as a single layer, as a double layer, and/or as a triple layer made of different materials.

A plurality of bit line capping layers 150 may be disposed on each of the plurality of bit lines BL. Each of the bit line capping layers 150 may be disposed on the upper surface of the corresponding bit line BL and extend long in the second horizontal direction Y. The bit line capping layer 150 may include, but not be limited to, at least one of silicon nitride (SiN), silicon oxide (SiO), and silicon oxynitride (SiON).

In some embodiments, bit line spacers BLS may be disposed on both sidewalls of each of the bit line BL and the bit line capping layer 150. The bit line spacer BLS may include a first spacer layer 152, a second spacer layer 154, and a third spacer layer 156 sequentially disposed on both sidewalls of the bit line BL and the upper surface and both sidewalls of the bit line capping layer 150. In optional or additional embodiments, the first spacer layer 152 and the third spacer layer 156 may include, but not be limited to, silicon nitride (SiN). Alternatively or additionally, the second spacer layer 154 may include, but not be limited to, silicon oxide (SiO).

In various embodiments, the bit line spacer BLS may extend over the upper surface of the second buffer insulating layer 116 on both sidewalls of the bit line BL. Alternatively or additionally, the bit line spacer BLS may cover the upper surface of the bit line contact DC and the upper surface of the bit line contact spacer DCS. As the inside of the bit line contact hole DCH may be filled with the bit line contact spacer DCS and the bit line contact DC in the damascene manner, the bit line spacer BLS may not extend into the bit line contact hole DCH. In one embodiment, the bit line spacers may at least partially cover a first upper surface of the second contact layer and a second upper surface of the second contact spacer layer. In one embodiment, the bit line spacers may not extend into the bit line contact hole.

An active pad hole APH extending into the substrate 110 may be formed between each of the plurality of bit lines BL. Alternatively or additionally, an active pad AP may be disposed in the active pad hole APH. In some embodiments, the active pad AP may include doped polysilicon. In optional or additional embodiments, the active pad AP may include, but not be limited to, at least one of titanium (Ti), titanium nitride (TiN), tantalum (Ta), tantalum nitride (TaN), ruthenium (Ru), cobalt (Co), molybdenum (Mo), tungsten (W), tungsten nitride (WN), titanium silicium nitride (TiSiN), tungsten silicon nitride (WSiN), cobalt silicide (CoSi), nickel silicide (NiSi), and tungsten silicide (WSi).

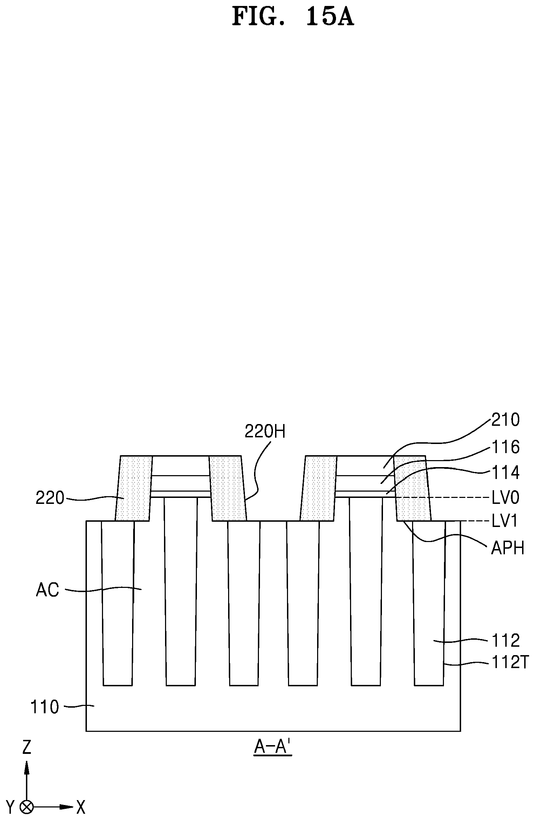

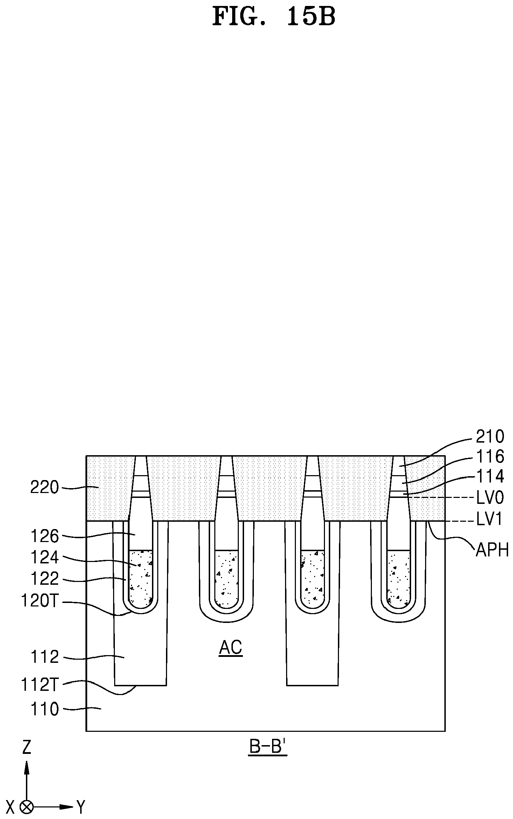

In various embodiments, the active pad hole APH may have an annular horizontal cross-section surrounding the bit line contact hole DCH. A pair of buried insulating patterns 140 may fill the remaining space of the active pad hole APH. In some embodiments, the active pad hole APH may have an elliptical or circular outer wall shape concentric with the bit line contact hole DCH. For example, after forming the active pad hole APH, a pad spacer 220 (e.g., as shown in FIG. 15A) having a predetermined width may be formed in the active pad hole APH, and the bit line contact hole DCH may be formed by further etching a portion of the substrate 110 along the inner wall of the pad spacer 220 using the pad spacer 220 as a self-alignment mask. In one embodiment, the active pad may be on a second active region of the plurality of active regions adjacent to the first active region, and the active pad may be disposed to face the bit line contact. In one embodiment, the active pad may face the bit line contact in a horizontal direction (e.g. the horizontal direction Y in FIG. 6). In one embodiment, the active pad may contact an outer wall of the first contact spacer layer.

As shown in FIG. 6, in a plan view, two active pads AP may be disposed on both sides of one bit line contact DC, and a bit line contact spacer DCS may be interposed between the bit line contact DC and the two active pads AP. For example, the pair of buried insulating patterns 140 may be spaced apart from each other in the second horizontal direction Y, and a bit line contact DC, a bit line contact spacer DCS, and an active pad AP may be disposed between the pair of buried insulating patterns 140. In one embodiment, an active pad may be disposed on each side of one bit line contact. In one embodiment, the bit line contact spacer may surround at least a first portion of the bit line contact. In one embodiment, the active pad may be disposed in an active pad hole extending into a second active region of the plurality of active regions adjacent to the first active region, and the active pad may surround at least a second portion of the bit line contact spacer.

As shown in FIG. 6, from a plan view, the active pad AP may include a first side surface AP_S1 contacting the active region AC and having a curved surface. The active pad AP may further include a second side surface AP_S2 contacting the bit line contact spacer DCS and having a curved surface. The active pad AP may further include a third side surface AP_S3 and a fourth side surface AP_S4 respectively contacting the pair of buried insulating patterns 140. For example, the first side surface AP_S1 and the second side surface AP_S2 of the active pad AP may form portions of concentric circles. In one embodiment, the active pad may comprise a first side surface contacting the first active region and having a first curved surface, and a second side surface contacting the first contact spacer layer and having a second curved surface. The first side surface of the active pad may form at least a first portion of one or more concentric circles and the second side of the active pad may form at least a second portion of the one or more concentric circles. In one embodiment, the active pad hole may form a concentric circle with the bit line contact hole and the active pad may contact an outer wall of the first contact spacer layer.

In some embodiments, as shown in FIG. 5, the active pad AP may include a sidewall AP_S that may be substantially vertical and/or inclined at a predetermined inclination angle. Alternatively or additionally, the active pad AP may have a substantially flat bottom surface AP_B. In some embodiments, the sidewall AP_S and bottom surface AP_B of the active pad AP may be connected at a relatively large inclination angle and the sidewall AP_S and bottom surface AP_B of the active pad AP may form a stepped portion, and thus, a contact area between the active pad AP and the active region AC may be relatively large. In one embodiment, a first side surface of the active pad and a bottom surface of the active pad may form a first stepped portion, and a second side surface of the active pad and a bottom surface of the active pad may form a second stepped portion. In one embodiment, the active pad hole may comprise a stepped portion at a boundary between a sidewall of the active pad hole and a bottom portion of the active pad hole, and the active pad may contact the second active region at the sidewall of the active pad hole and the bottom portion of the active pad hole.

In some embodiments, the active pad AP may have an upper surface disposed at the same level as the upper surface of the pair of buried insulating patterns 140. In some embodiments, the bottom surface AP_B of the active pad AP may be disposed at a first vertical level LV1 that may be lower than the reference level LV0. Alternatively or additionally, a bottom surface of the first contact layer 132 of the bit line contact DC may be disposed at a second vertical level LV2 that may be lower than the first vertical level LV1. In optional or additional embodiments, the upper surface of the first contact layer 132 of the bit line contact DC may be disposed at a third vertical level LV3 that may be lower than the first vertical level LV1 and/or may be higher than the second vertical level LV2. As used herein, the reference level LV0 may indicate a level on which the upper surface of the substrate 110 may be disposed, a level lower than the reference level LV0 may indicate a level disposed inside the substrate 110, and a level higher than the reference level LV0 may indicate a level spaced from the substrate 110 to the outside of the substrate 110. For example, as the upper surface of the first contact layer 132 having a relatively large first width w11 may be disposed at a level lower than the bottom surface AP_B of the active pad AP, a relatively large separation distance may be secured between the first contact layer 132 and the active pad AP. Thereby, electrical performance of the semiconductor device 100 may be potentially improved, when compared to related semiconductor devices.

A plurality of buried contacts BC may be disposed on the upper surface of the active pad AP between the plurality of bit lines BL. In some embodiments, the plurality of buried contacts BC may include doped polysilicon. In optional or additional embodiments, the plurality of buried contacts BC may include, but not be limited to, at least one of titanium (Ti), titanium nitride (TiN), tantalum (Ta), tantalum nitride (TaN), ruthenium (Ru), cobalt (Co), molybdenum (Mo), tungsten (W), tungsten nitride (WN), titanium silicium nitride (TiSiN), tungsten silicon nitride (WSiN), cobalt silicide (CoSi), nickel silicide (NiSi), and tungsten silicide (WSi).

An insulation fence 158 may be disposed to extend in the first horizontal direction X between two adjacent bit lines BL. The insulation fence 158 may be disposed at a position vertically overlapping the plurality of word line trenches 120T. The insulation fence 158 may be disposed to be spaced apart in the second horizontal direction Y and extend in the vertical direction Z between two adj acent bit lines BL. From a plan view, the plurality of buried contacts BC and the insulation fence 158 may be alternately disposed between the two bit lines BL extending in the second horizontal direction Y.

A plurality of landing pads LP may be disposed on the plurality of buried contacts BC. Each of the plurality of landing pads LP may include a landing pad barrier 162 and a landing pad conductive layer 164. The landing pad barrier 162 may include, but not be limited to, titanium (Ti), titanium nitride (TiN), and/or a combination thereof. The landing pad conductive layer 164 may include, but not be limited to, metal, metal nitride, conductive polysilicon, and/or a combination thereof. For example, the landing pad conductive layer 164 may include tungsten (W). In some embodiments, the plurality of landing pads LP may have a plurality of island-shaped pattern shapes in a plan view.

The plurality of landing pads LP may be electrically insulated from each other by an insulating pattern 166 surrounding the plurality of landing pads LP. The insulating pattern 166 may be disposed in a landing pad opening LPH. As used herein, the landing pad opening LPH may refer to a space formed by removing portions of the landing pad barrier 162 and the landing pad conductive layer 164 and portions of the bit line capping layer and the bit line spacer BLS. The insulating pattern 166 may include, but not be limited to, at least one of silicon nitride (SiN), silicon oxide (SiO), and silicon oxynitride (SiON).

An etch stop layer 170 may be disposed on the plurality of landing pads LP and the insulating pattern 166. The capacitor structure CAP may be disposed on the etch stop layer 170. The capacitor structure CAP may include a lower electrode 172, a capacitor dielectric layer 174, and an upper electrode 176. The lower electrode 172 may pass through the etch stop layer 170 and contact the upper surface of the landing pad LP. In optional or additional embodiments, instead of disposing the capacitor structure CAP, a memory element such as, but not limited to, a magnetic tunnel junction, a phase change memory element, and/or a variable resistance memory element may be disposed.

In a related process, a bit line contact may be formed by patterning a bit line and etching a side portion of the bit line contact disposed under the bit line to reduce the width of the bit line contact. However, as the spacing between bit lines may be reduced, the difficulty of etching the bit line contacts may increase and/or may be very high. Alternatively or additionally, a process of forming a buried contact between an active region and a landing pad in a space between bit lines may also be difficult.

According to embodiments, after forming the pad spacer 220 (see, for example, FIG. 15A) in the active pad hole APH, the bit line contact DC may be formed in a damascene method, and subsequently, the active pad AP may be formed after removing the pad spacer. Accordingly, the difficulty of a process of patterning the bit line contact DC may be reduced. In addition, since a relatively large contact area may be secured between the active pad AP formed in the active pad hole APH and the active region AC, the semiconductor device 100 may have an improved electrical performance, when compared to related semiconductor devices.

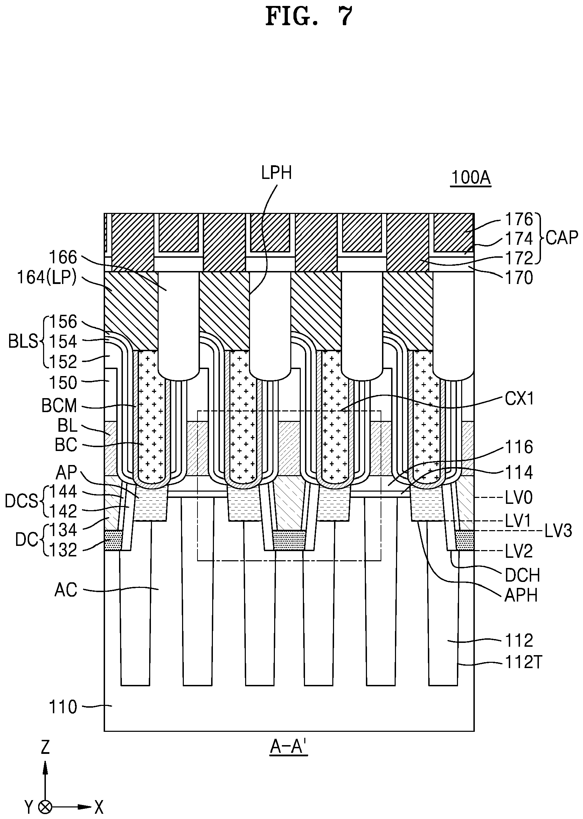

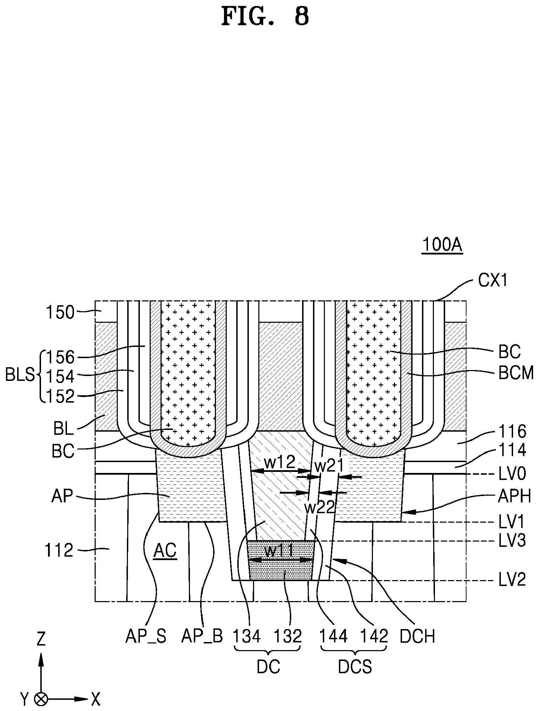

FIG. 7 is a cross-sectional view illustrating a semiconductor device 100A, according to various embodiments. FIG. 8 is an enlarged view of a portion CX1 of FIG. 7, according to various embodiments. Semiconductor device 100A of FIGS. 7 and 8 may include and/or may be similar in many respects to the semiconductor device 100 described above with reference to FIGS. 1-6, and may include additional features not mentioned above. Consequently, repeated descriptions of the semiconductor device 100A described above with reference to FIGS. 1-6 may be omitted for the sake of brevity.

Referring to FIGS. 1 and 8, a thin conductive barrier layer BCM may be disposed between an active pad AP and a buried contact BC. The conductive barrier layer BCM may be between a top surface of the active pad AP and a bottom surface of the buried contact BC. Alternatively or additionally, the conductive barrier layer BCM may be disposed to surround at least a portion of a sidewall of the buried contact BC.

In some embodiments, the conductive barrier layer BCM may be only between two sidewalls spaced apart from each other in a first horizontal direction X of the buried contact BC and a bit line spacer BLS. Alternatively or additionally, the conductive barrier layer BCM may not be between the insulation fence 158 and the two sidewalls spaced apart from each other in a second horizontal direction Y of the buried contact BC.

In optional or additional embodiments, the conductive barrier layer BCM may be both between the bit line spacer BLS and the two sidewalls spaced apart in the first horizontal direction X of the buried contact BC and between the insulation fence 158 and the two sidewalls spaced apart in the second horizontal direction Y of the buried contact BC. In such embodiments, the conductive barrier layer BCM may surround the entire sidewall of the buried contact BC.

In some embodiments, the conductive barrier layer BCM may include, but not be limited to, at least one of titanium (Ti), titanium nitride (TiN), tantalum (Ta), tantalum nitride (TaN), ruthenium (Ru), cobalt (Co), molybdenum (Mo), tungsten (W), tungsten nitride (WN), titanium silicium nitride (TiSiN), tungsten silicon nitride (WSiN), cobalt silicide (CoSi), nickel silicide (NiSi), and tungsten silicide (WSi). Alternatively or additionally, the plurality of buried contacts BC may include, but not be limited to, at least one of titanium (Ti), titanium nitride (TiN), tantalum (Ta), tantalum nitride (TaN), ruthenium (Ru), cobalt (Co), molybdenum (Mo), tungsten (W), tungsten nitride (WN), titanium silicium nitride (TiSiN), tungsten silicon nitride (WSiN), cobalt silicide (CoSi), nickel silicide (NiSi), and tungsten silicide (WSi).

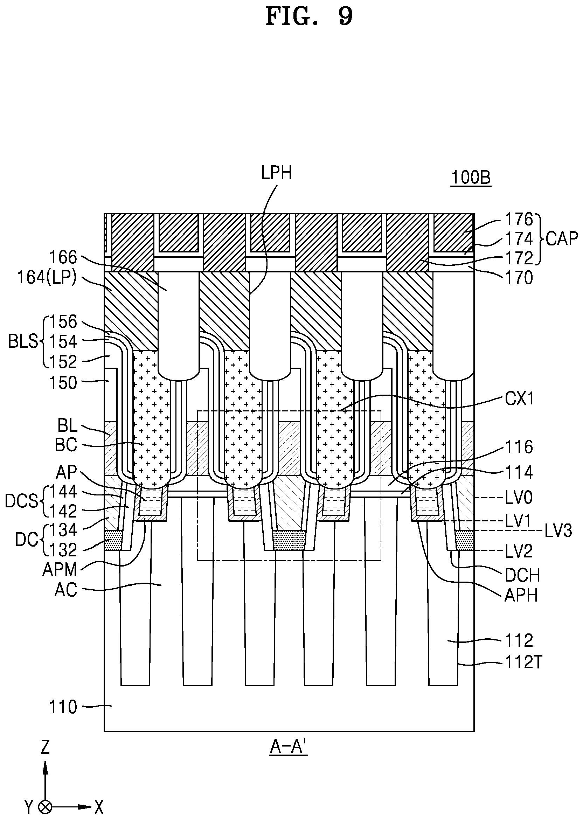

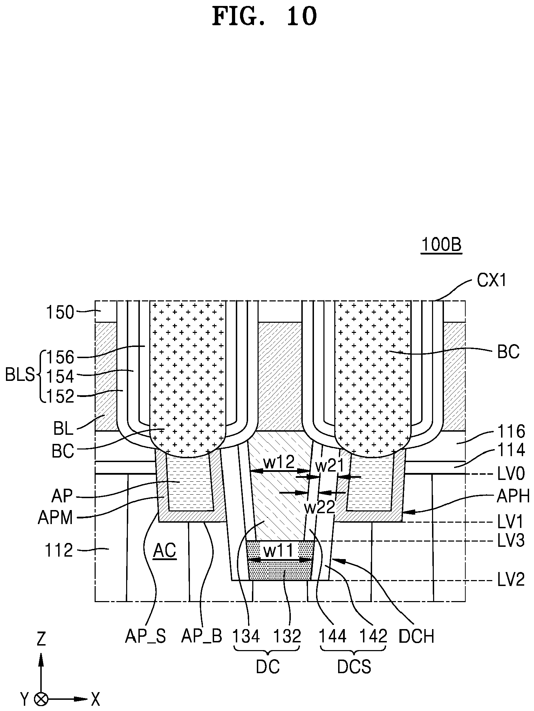

FIG. 9 is a cross-sectional view illustrating a semiconductor device 100B, according to various embodiments. FIG. 10 is an enlarged view of a portion CX1 of FIG. 9, according to various embodiments. Semiconductor device 100B of FIGS. 9 and 10 may include and/or may be similar in many respects to at least one of the semiconductor device 100 and the semiconductor device 100A described above with reference to FIGS. 1-8, and may include additional features not mentioned above. Consequently, repeated descriptions of the semiconductor device 100B described above with reference to FIGS. 1-8 may be omitted for the sake of brevity.

Referring to FIGS. 9 and 10, a conductive barrier layer APM may be disposed on sidewalls and bottom surfaces of the active pad AP to have a small thickness. The conductive barrier layer APM may be between the active pad AP and the active region AC and between the active pad AP and the bit line contact spacer DCS. In some embodiments, the conductive barrier layer APM may be configured to prevent direct contact between the active pad AP and the active region AC. In some embodiments, the conductive barrier layer APM may include, but not be limited to, at least one of titanium (Ti), titanium nitride (TiN), tantalum (Ta), tantalum nitride (TaN), ruthenium (Ru), cobalt (Co), molybdenum (Mo), tungsten (W), tungsten nitride (WN), titanium silicium nitride (TiSiN), tungsten silicon nitride (WSiN), cobalt silicide (CoSi), nickel silicide (NiSi), and tungsten silicide (WSi).

In some embodiments, the active pad AP may include at least one of titanium (Ti), titanium nitride (TiN), tantalum (Ta), tantalum nitride (TaN), ruthenium (Ru), cobalt (Co), molybdenum (Mo), tungsten (W), tungsten nitride (WN), titanium silicium nitride (TiSiN), tungsten silicon nitride (WSiN), cobalt silicide (CoSi), nickel silicide (NiSi), and tungsten silicide (WSi).

In some embodiments, the active pad AP may include a substantially similar material and/or the same material as that of the bit line contact DC (e.g., the material of the second contact layer 134). For example, in a state in which the space defined by the inner space of the active pad hole APH and the inner wall of the second contact spacer layer 144 disposed in the bit line contact hole DCH may be exposed, the active pad AP and the second contact layer 134 may be simultaneously formed by filling the inner space of the active pad hole APH and the remaining space of the bit line contact hole DCH. In such a case, the active pad AP may include the same material as that of the bit line contact DC. In some embodiments, a conductive barrier layer APM may be selectively formed on the inner wall of the active pad hole APH before forming the active pad AP and the bit line contact DC. In optional or additional embodiments, the conductive barrier layer APM may be formed simultaneously with the first contact layer 132 in the process of forming the first contact layer 132.

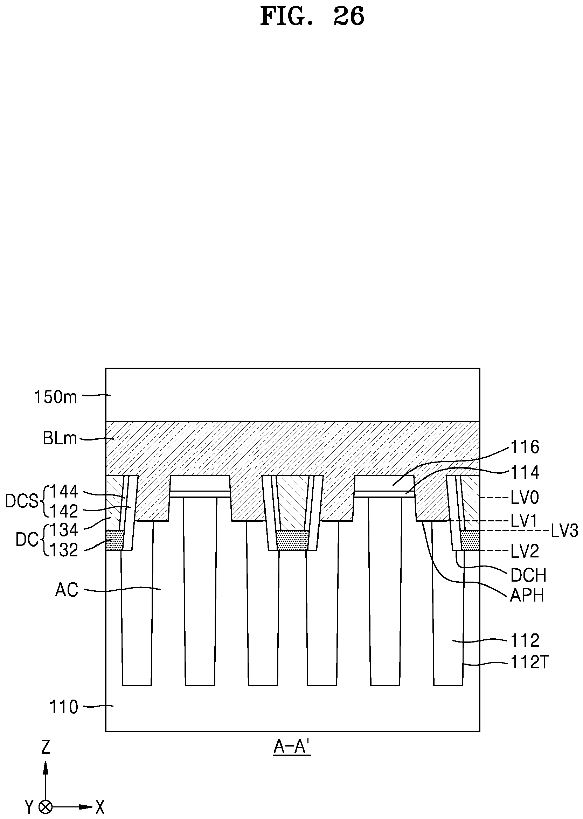

In other optional or additional embodiments, the active pad AP may include a substantially similar and/or the same material as that of the bit line BL. For example, when the inner space of the active pad hole APH is not filled and exposed, a bit line conductive layer BLm (e.g., as shown in FIG. 26) may be formed to a relatively large height while filling the inner space of the active pad hole APH. In such a case, the active pad AP may include the same material as that of the bit line BL.

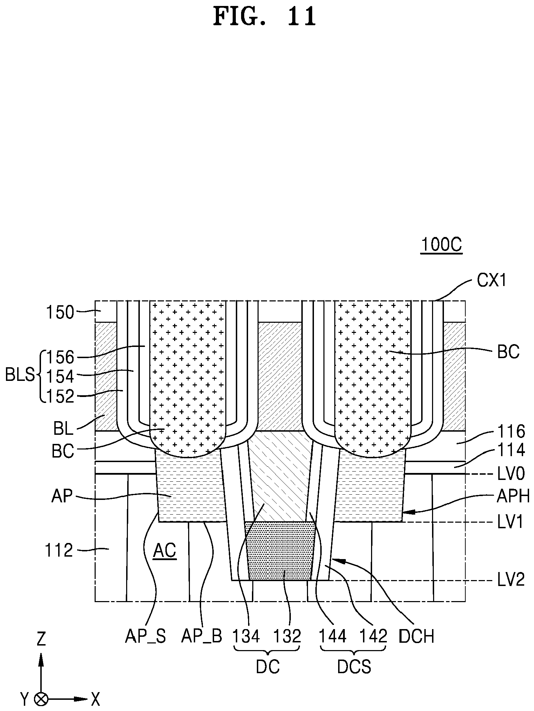

FIG. 11 is a cross-sectional view illustrating a semiconductor device 100C, according to various embodiments. Semiconductor device 100C of FIG. 11 may include and/or may be similar in many respects to at least one of the semiconductor devices 100, 100A, and 100B described above with reference to FIGS. 1-10, and may include additional features not mentioned above. Consequently, repeated descriptions of the semiconductor device 100C described above with reference to FIGS. 1-10 may be omitted for the sake of brevity.

Referring to FIG. 11, a bottom surface AP_B of the active pad AP may be disposed at a first vertical level LV1. The bottom surface of the first contact layer 132 of the bit line contact DC may be disposed at a second vertical level LV2 that may be lower than the first vertical level LV1. Alternatively or additionally, the upper surface of the first contact layer 132 of the bit line contact DC may be disposed at the first vertical level LV1. Accordingly, the bottom surface of the second contact layer 134 disposed on the first contact layer 132 may be disposed at a substantially similar and/or the same level as the bottom surface AP_B of the active pad AP.

Although FIG. 11 shows that the upper surface of the first contact layer 132 of the bit line contact DC may be disposed on the first vertical level LV1, the present disclosure is not limited in this regard. For example, in optional or additional embodiments, the top surface of the first contact layer 132 (and/or the bottom surface of the second contact layer 134) may be disposed at a level higher than the first vertical level LV1. In such embodiments, a vertical distance between the top surface of the substrate 110 and the top surface of the first contact layer 132 (and/or the vertical distance between the top surface of the substrate 110 and the bottom surface of the second contact layer 134) may be less than a vertical distance between the top surface of the substrate 110 and the bottom surface AP_B of the active pad AP.

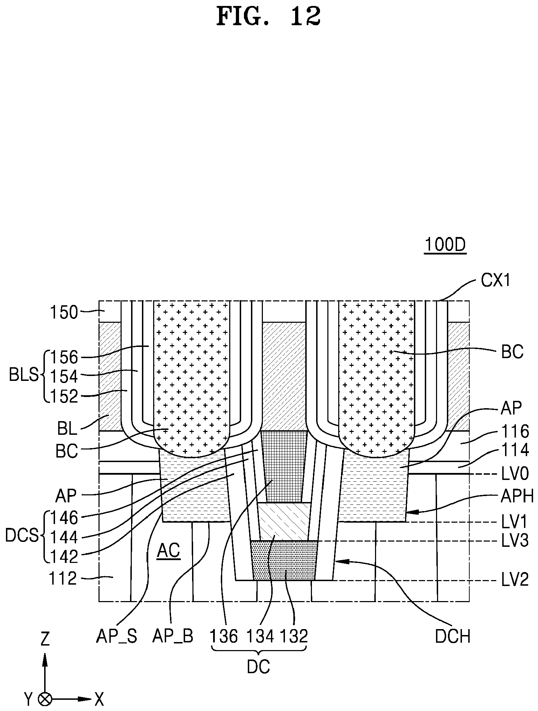

FIG. 12 is a cross-sectional view illustrating a semiconductor device 100D, according to various embodiments. Semiconductor device 100D of FIG. 12 may include and/or may be similar in many respects to at least one of the semiconductor devices 100, 100A, 100B, and 100C described above with reference to FIGS. 1-11, and may include additional features not mentioned above. Consequently, repeated descriptions of the semiconductor device 100D described above with reference to FIGS. 1-11 may be omitted for the sake of brevity.

Referring to FIG. 12, the bit line contact DC may include a first contact layer 132, a second contact layer 134, and a third contact layer 136. The bit line contact spacer DCS may include a first contact spacer layer 142, a second contact spacer layer 144, and a third contact spacer layer 146. The first contact layer 132 may be disposed on the bottom of the bit line contact hole DCH. Alternatively or additionally, sidewalls of the first contact layer 132 may be surrounded by the first contact spacer layer 142. The second contact layer 134 may be disposed on the first contact layer 132, and/or a sidewall of the second contact layer 134 may be surrounded by the second contact spacer layer 144. The third contact layer 136 may be disposed on the second contact layer 134. Alternatively or additionally, a sidewall of the third contact layer 136 may be surrounded by the third contact spacer layer 146.

In some embodiments, the first contact spacer layer 142 may be disposed on an entire sidewall of the bit line contact hole DCH, the second contact spacer layer 144 may be disposed on an upper side of the inner wall of the first contact spacer layer 142, and the third contact spacer layer 146 may be disposed on an upper side of the inner wall of the second contact spacer layer 144. Accordingly, the horizontal width of the second contact layer 134 may be less (e.g., narrower) than the horizontal width of the first contact layer 132. Alternatively or additionally, the horizontal width of the third contact layer 136 may be less (e.g., narrower) than the horizontal width of the second contact layer 134.

According to embodiments, the first to third contact layers 132 to 136 may be formed in the damascene method using the first to third contact spacer layers 142 to 146 as self-alignment spacers. Accordingly, the widths of the first to third contact layers 132 to 136 may be adjusted based on the required shape and/or profile of the bit line contact DC.

Although FIG. 12 illustrates that the bit line contact DC includes first to third contact layers 132 to 136, the present disclosure is not limited in this regard. For example, in optional or additional embodiments, the bit line contact DC may further include an additional contact layer.

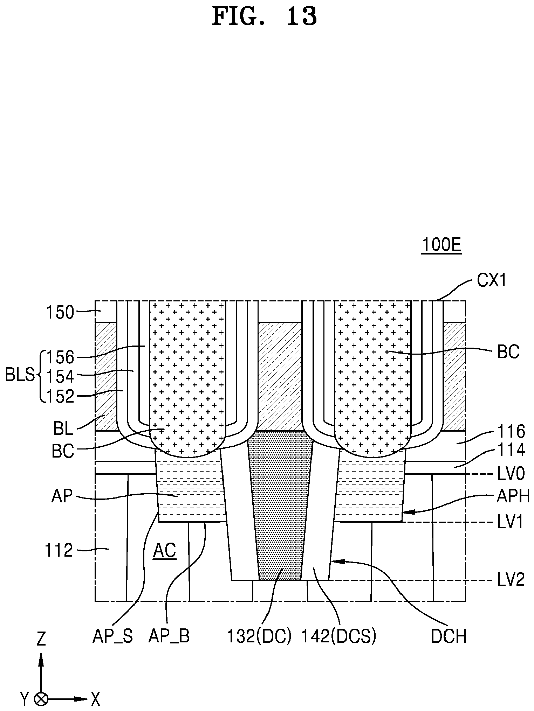

FIG. 13 is a cross-sectional view illustrating a semiconductor device 100E, according to various embodiments. Semiconductor device 100E of FIG. 13 may include and/or may be similar in many respects to at least one of the semiconductor devices 100, 100A, 100B, 100C, and 100D described above with reference to FIGS. 1-12, and may include additional features not mentioned above. Consequently, repeated descriptions of the semiconductor device 100E described above with reference to FIGS. 1-12 may be omitted for the sake of brevity.

Referring to FIG. 13, the bit line contact DC may include only the first contact layer 132 (132(DC)), and/or the bit line contact spacer DCS may include only the first contact spacer layer 142 (142(DCS)). The sidewall of the first contact layer 132 may be surrounded by the first contact spacer layer 142, and the first contact layer 132 may fill the inner space of the bit line contact hole DCH. The top surface of the first contact layer 132 may contact the bit line BL and the bit line spacer BLS.

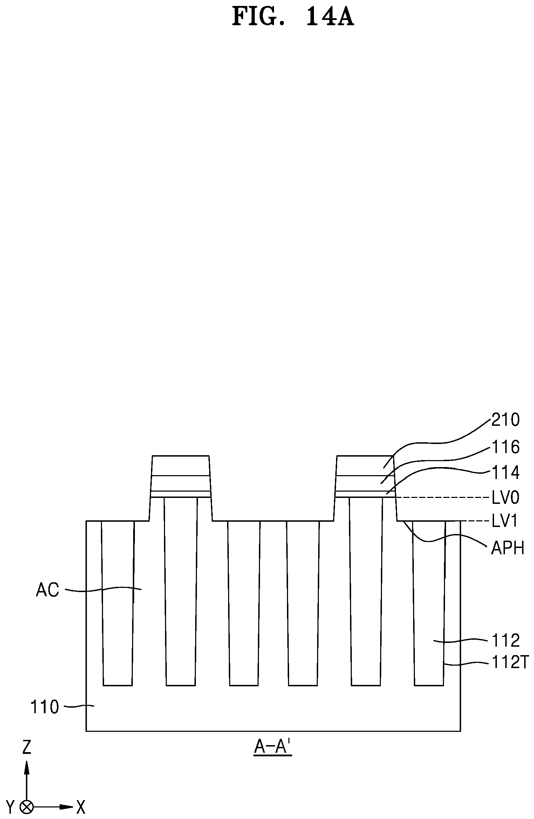

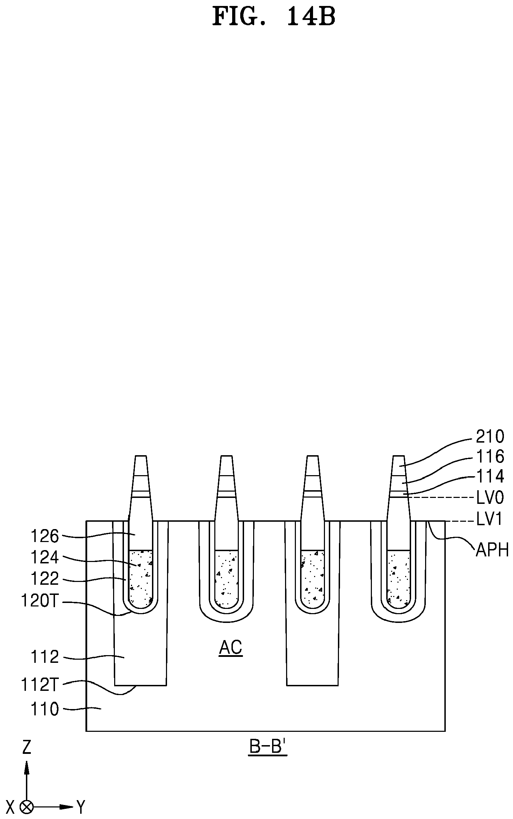

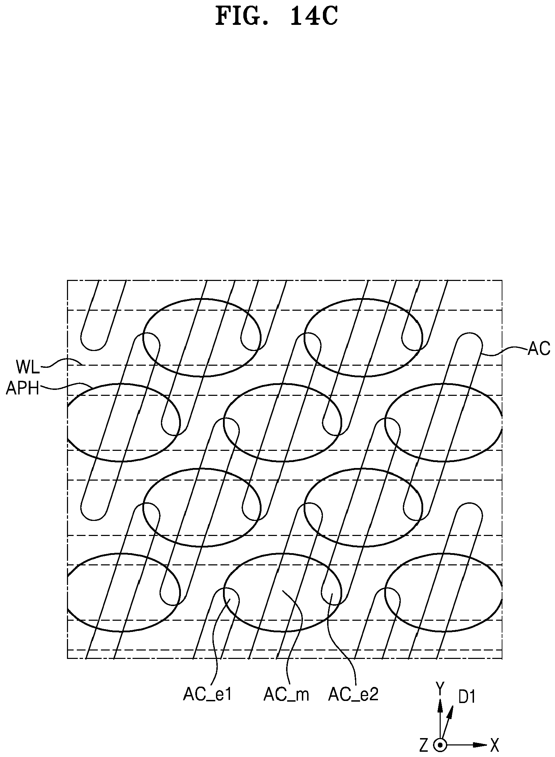

FIGS. 14A to 24C are cross-sectional views illustrating a method of manufacturing a semiconductor device, according to various embodiments. Referring FIGS. 14A, 15A, 16, 17A, 18A, 19A, 20A, 22A, 23, and 24A, cross-sectional views corresponding to the A-A' section of FIG. 2 are illustrated. Referring to FIGS. 14B, 15B, 20B, 21, 22B, and 24B, cross-sectional views corresponding to the B-B' section of FIG. 2 are illustrated. Referring to FIGS. 14C, 15C, 17B, 18B, 19B, 20C, 22C, and 24C, top views of FIGS. 14A, 15A, 17A, 18A, 19A, 20A, 22A, and 24A are illustrated, respectively.

Referring to FIGS. 14A to 14C, a plurality of device isolation trenches 112T may be formed in the cell array region MCA of the substrate 110.

Thereafter, a device isolation layer 112 filling the plurality of device isolation trenches 112T may be formed. A plurality of active regions AC may be defined on the substrate 110 by forming the device isolation layer 112. The plurality of active regions AC may extend in a first oblique direction D1 that may be inclined at a predetermined angle with a first horizontal direction X and a second horizontal direction Y.

In some embodiments, the device isolation layer 112 may be formed using, but not be limited to, at least one of silicon oxide (SiO), silicon nitride (SiN), silicon oxynitride (SiON), and/or a combination thereof. In some examples, the device isolation layer 112 may have a double-layer structure including, but not be limited to, a silicon oxide (SiO) layer and a silicon nitride (SiN) layer. However, the present disclosure is not limited thereto.

A mask pattern (not shown) may be formed on the substrate 110, and a portion of the substrate 110 may be removed using the mask pattern as an etching mask to form a word line trench 120T. For example, a mask pattern for forming the word line trench 120T may be formed using double patterning technology (DPT) and/or quadruple patterning technology (QPT). However, the present disclosure is not limited thereto.

Thereafter, a gate dielectric layer 122, a gate electrode 124, and a word line capping layer 126 may be sequentially formed in the word line trench 120T.

For example, the gate dielectric layer 122 may be conformally disposed on the inner wall of the word line trench 120T. The gate electrode 124 may be formed by filling the word line trench 120T with a conductive layer (not shown) and then exposing an upper portion of the word line trench 120T again by etching back an upper portion of the conductive layer.

Thereafter, a first buffer insulating layer 114, a second buffer insulating layer 116, and a cover insulating layer 210 may be formed on the active region AC and the device isolation layer 112. A mask pattern (not shown) may be formed on the cover insulating layer 210, and an active pad hole APH may be formed by removing portions of the first buffer insulating layer 114, the second buffer insulating layer 116, the cover insulating layer 210, and the substrate 110 by using the mask pattern as an etch mask.

In some embodiments, the active pad hole APH may have an elliptical horizontal cross-section having a relatively large width in the first horizontal direction X. For example, the center point of the active pad hole APH may overlap the center point of the corresponding active region AC, and one active pad hole APH may expose upper surfaces of the three active regions AC in the first horizontal direction X. For example, the upper surface of the main active region AC_m may be exposed at the center of one active pad hole APH. Alternatively or additionally, upper surfaces of the first and second edge active regions AC_e1 and AC_e2 may be exposed on both sides of one active pad hole APH, respectively. Accordingly, the first edge active region AC_e1, the main active region AC_m, and the second edge active region AC_e2 may be sequentially spaced apart from each other in the first horizontal direction X at the bottom of one active pad hole APH.

Referring to FIGS. 15A to 15C, a pad spacer 220 may be formed on the inner wall of the active pad hole APH. In some embodiments, the pad spacer 220 may be formed using, but not limited to, silicon oxide (SiO), silicon nitride (SiN), silicon oxynitride (SiON), and/or a combination thereof.

In various embodiments, the pad spacer 220 may be formed to have a relatively large thickness so as to cover at least a portion of the first and second edge active regions AC_e1 and AC_e2 while exposing the upper surface of the main active region AC_m. In optional or additional embodiments, an inner wall 220H of the pad spacer 220 may have an elliptical and/or circular horizontal cross-section concentric with the active pad hole APH.

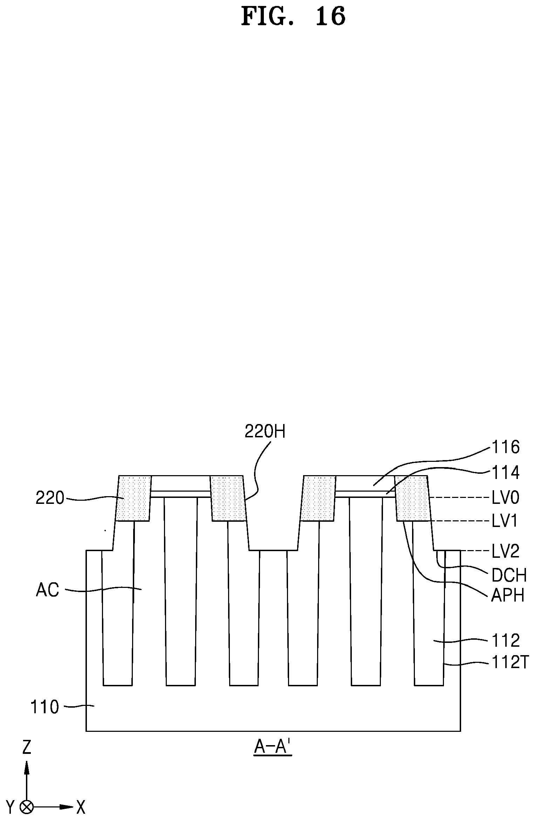

Referring to FIG. 16, a bit line contact hole DCH may be formed by further etching a portion of the substrate 110 exposed to a space surrounded by the inner wall 220H of the pad spacer 220 using the pad spacer 220 as a self-alignment mask. In a process of forming the bit line contact hole DCH, a portion of the cover insulating layer 210 and an upper side of the pad spacer 220 may be removed by a partial thickness. Accordingly, the upper surface of the pad spacer 220 may be disposed at a substantially similar and/or the same vertical level as the upper surface of the second buffer insulating layer 116.

In some embodiments, the bit line contact hole DCH may be formed to continuously extend along with the inner wall 220H of the pad spacer 220. The active pad hole APH may have a bottom disposed at a first vertical level LV1 that may be lower than the reference level LV0, and the bit line contact hole DCH may have a bottom disposed at a second vertical level LV2 that may be lower than the first vertical level LV1.

For example, the bit line contact hole DCH may have an elliptical and/or circular horizontal cross-section concentric with the active pad hole APH.

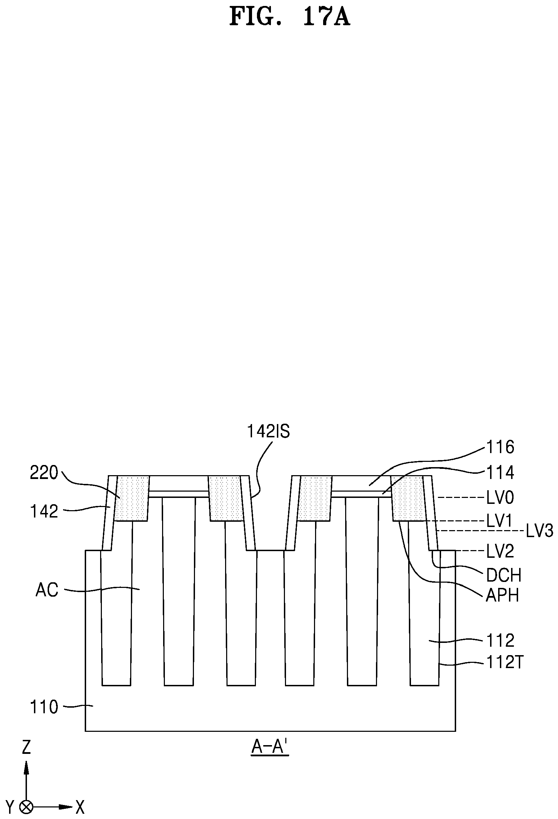

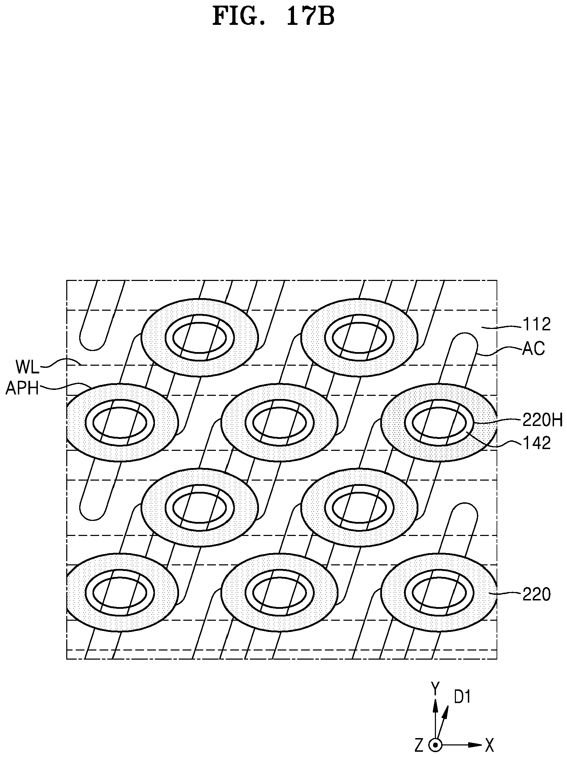

Referring to FIGS. 17A and 17B, a first contact spacer layer 142 may be formed on the inner wall 220H of the pad spacer 220. The first contact spacer layer 142 may be formed on the inner wall of the bit line contact hole DCH and may have an annular shape in a plan view. The first contact spacer layer 142 may be formed to have a first thickness w21 (e.g., as shown in FIG. 6). In some embodiments, the first contact spacer layer 142 may be formed using, but not limited to, silicon nitride (SiN), silicon oxynitride (SiON), and/or a combination thereof.

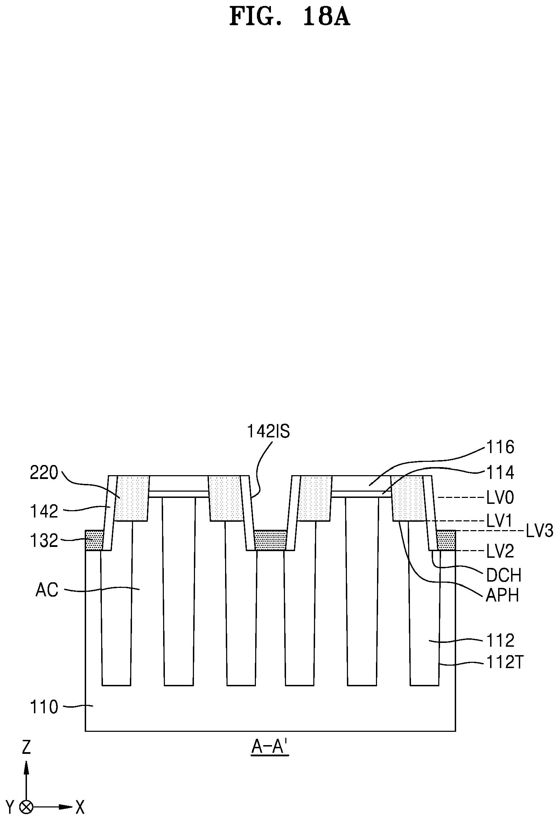

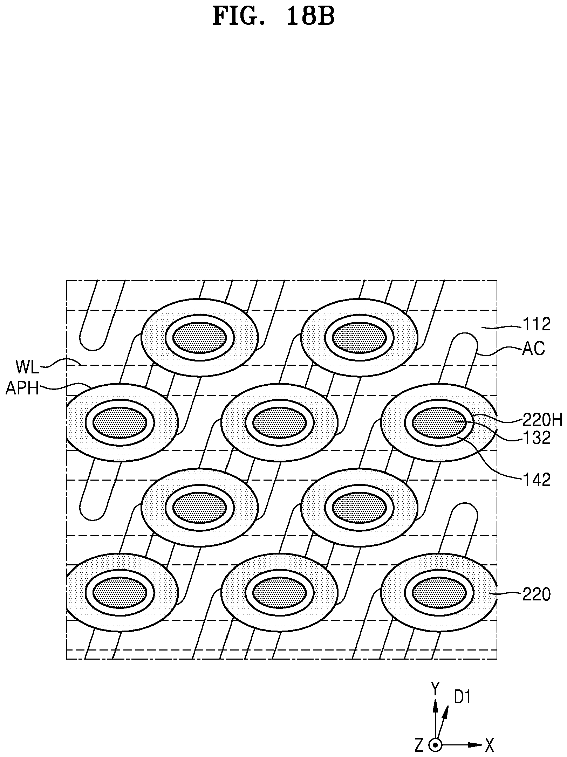

Referring to FIGS. 18A and 18B, the first contact layer 132 may be formed on the bottom of the bit line contact hole DCH. The first contact layer 132 may have an upper surface positioned at a third level LV3 that may be higher than the second vertical level LV2 and/or lower than a first vertical level LV1. In some embodiments, the first contact layer 132 may be formed using, but not limited to, at least one of titanium (Ti), titanium nitride (TiN), tantalum (Ta), tantalum nitride (TaN), ruthenium (Ru), cobalt (Co), molybdenum (Mo), tungsten (W), tungsten nitride (WN), titanium silicium nitride (TiSiN), tungsten silicon nitride (WSiN), cobalt silicide (CoSi), nickel silicide (NiSi), and tungsten silicide (WSi).

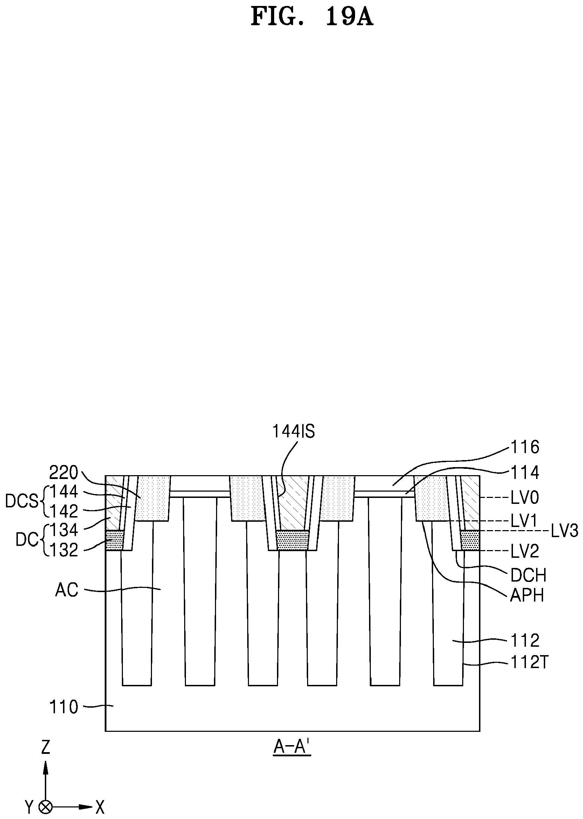

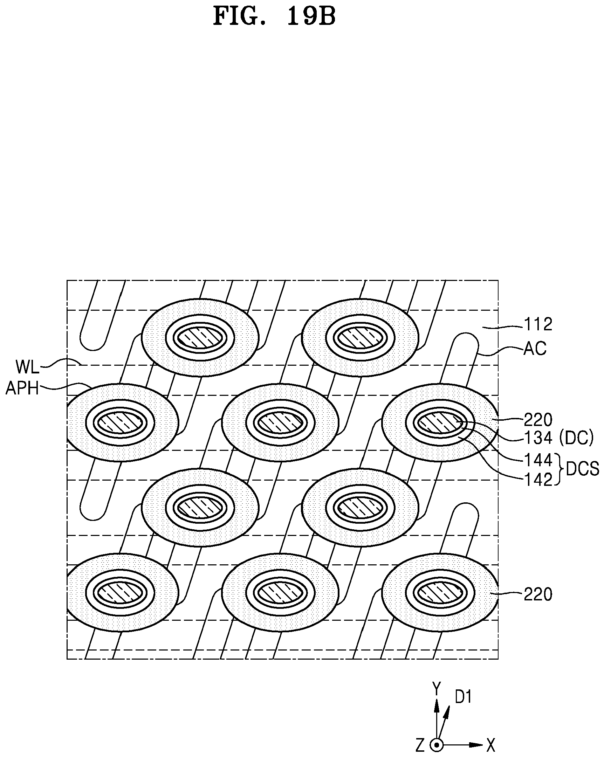

Referring to FIGS. 19A and 19B, a second contact spacer layer 144 may be formed on a sidewall of the bit line contact hole DCH (e.g., on an inner wall 142IS of the first contact spacer layer 142). The second contact spacer layer 144 may be formed using, but not be limited to, at least one of silicon nitride (SiN), silicon oxynitride (SiON), and/or a combination thereof. In some embodiments, the second contact spacer layer 144 may be formed to have a second thickness w22 (e.g., as shown in FIG. 6) independent of the first thickness w21 of the first contact spacer layer 142. In some optional or additional embodiments, the second thickness w22 may be less (e.g., thinner) than the first thickness w21.

Subsequently, the second contact layer 134 may be formed on the inner wall of the bit line contact hole DCH. For example, the second contact layer 134 may be formed on the inner wall 144IS of the second contact spacer layer 144 and on the upper surface of the first contact layer 132. In some embodiments, the first contact layer 132 may be formed using, but not be limited to, at least one of titanium (Ti), titanium nitride (TiN), tantalum (Ta), tantalum nitride (TaN), ruthenium (Ru), cobalt (Co), molybdenum (Mo), tungsten (W), tungsten nitride (WN), titanium silicium nitride (TiSiN), tungsten silicon nitride (WSiN), cobalt silicide (CoSi), nickel silicide (NiSi), and tungsten silicide (WSi).

In some embodiments, the second contact layer 134 may be formed inside the bit line contact hole DCH in a damascene manner. For example, the second contact layer 134 may fill a space defined by an inner wall 144IS of the second contact spacer layer 144 and the upper surface of the first contact layer 132. The upper surface of the second contact layer 134 may be disposed on a substantially similar and/or the same plane as upper surfaces of the second buffer insulating layer 116 and the pad spacer 220.

As used herein, the first contact layer 132 and the second contact layer 134 may be referred to as bit line contacts DC. Alternatively or additionally, the first contact spacer layer 142 and the second contact spacer layer 144 may be referred to as bit line contact spacers DCS. According to aspects of the present disclosure, a structure may be obtained in which the bit line contact DC may be surrounded by the bit line contact spacer DCS, an upper side of the bit line contact DC may be surrounded by a pad spacer 220 within the active pad hole APH, and a lower side of the bit line contact DC may be disposed in the bit line contact hole DCH to contact the upper surface of the active region AC.

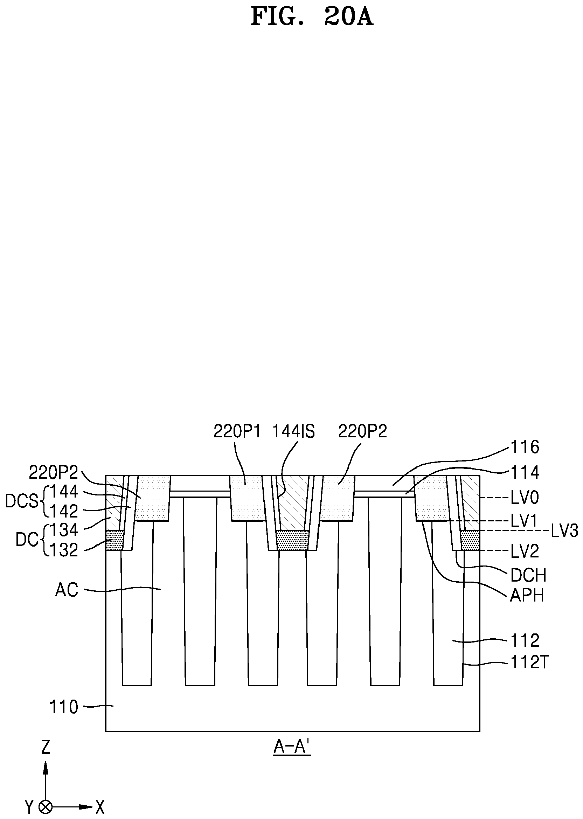

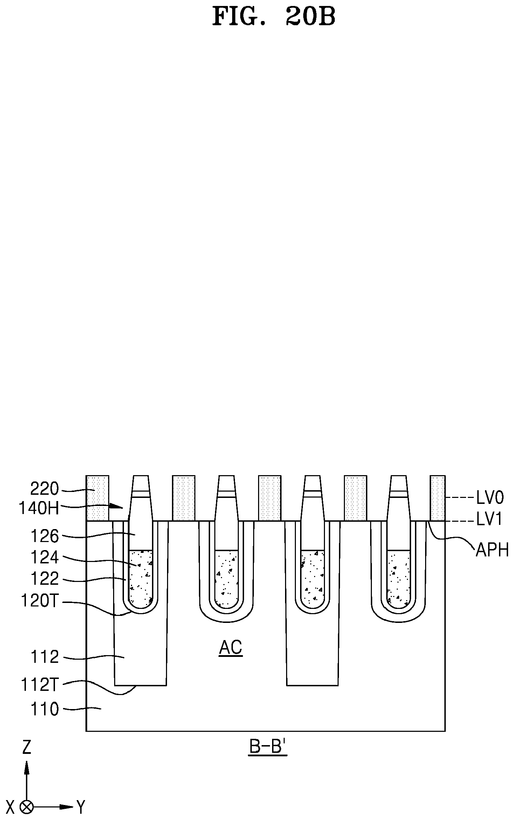

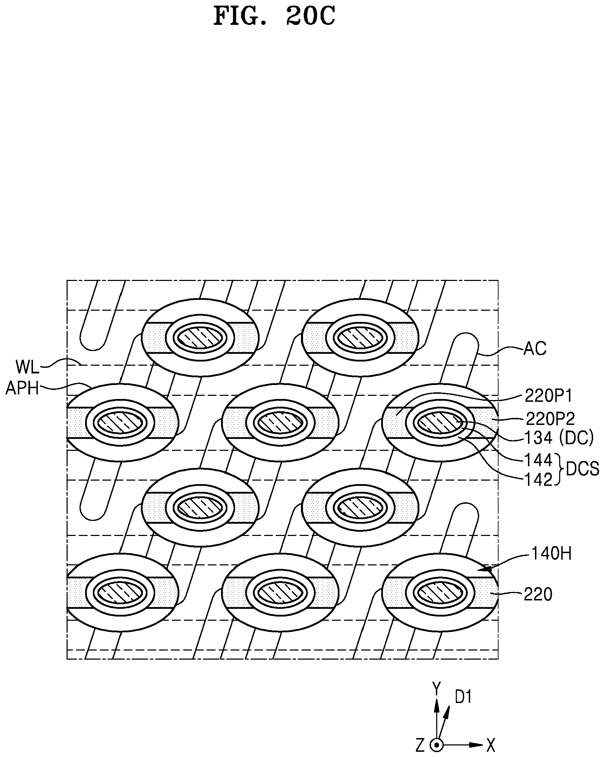

Referring to FIGS. 20A to 20C, a pair of recesses 140H may be formed by removing a portion of the pad spacer 220 through a trimming process. For example, portions of the pad spacer 220 remaining by removing a portion of the pad spacer 220 may be referred to as a first portion 220P1 and a second portion 220P2. Through the trimming process, a structure may be obtained in which the first portion 220P1, the bit line contact DC, and the second part 220P2 may be sequentially disposed in the active pad hole APH in the first horizontal direction X. When the bit line contact DC is surrounded by the bit line contact spacer DCS, the bit line contact spacer DCS may be between the first portion 220P1 and the bit line contact DC and between the second portion 220P2 and the bit line contact DC.

The pair of recesses 140H may expose a portion of the word line capping layer 126 disposed apart from the bit line contact DC in the second horizontal direction Y. Alternatively or additionally, the pair of recesses 140H may be formed in one active pad hole APH, and both sidewalls spaced apart from each other in the second horizontal direction Y of the bit line contact spacer DCS may be respectively exposed through the pair of recesses 140H.

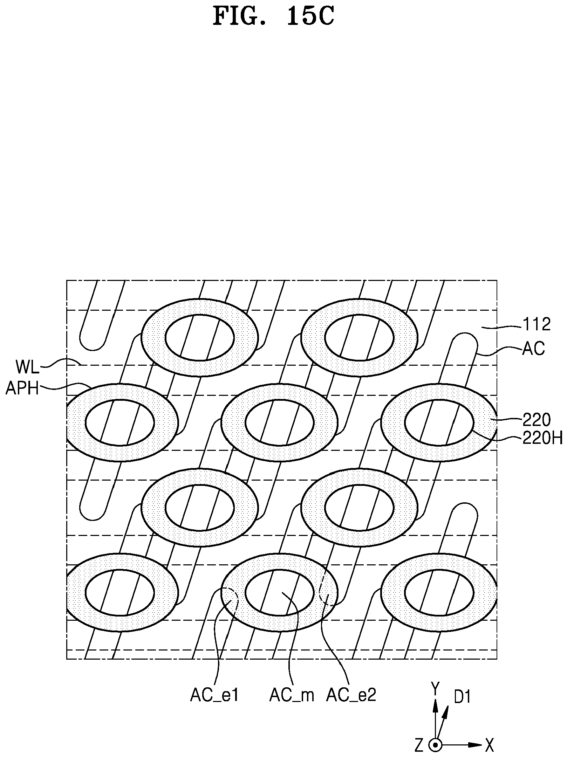

In some embodiments, the first portion 220P1 of the pad spacer 220 may be disposed to cover the first edge active area AC_e1 (e.g., as shown in FIG. 15C). Alternatively or additionally, the second part 220P2 of the pad spacer 220 may be disposed to cover the second edge active area AC_e2 (e.g., as shown in FIG. 15C).

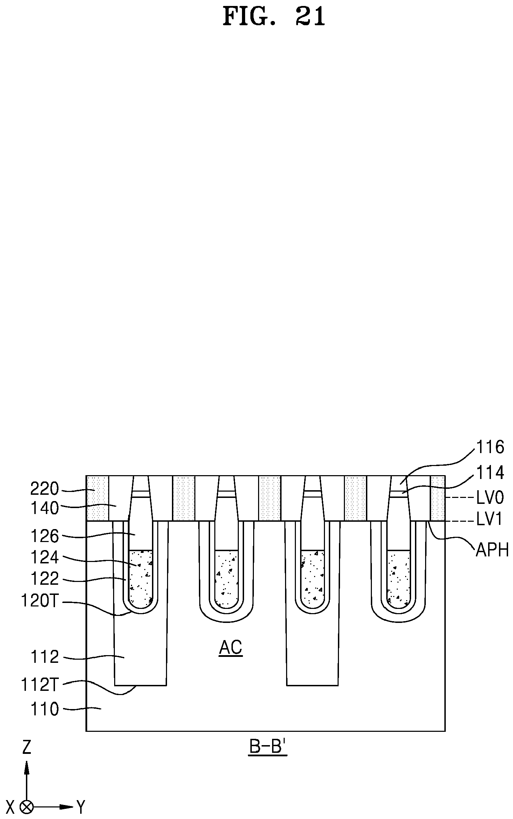

Referring to FIG. 21, a pair of buried insulating patterns 140 may be formed in the pair of recesses 140H. The pair of buried insulating patterns 140 may be formed to fill a remaining space in the active pad hole APH except for the first portion 220P 1, the bit line contact DC, and the second portion 220P2, which may be sequentially disposed in the first horizontal direction X. For example, each of the pair of buried insulating patterns 140 may be formed to contact sidewalls of the active pad hole APH and sidewalls of the bit line contact spacer DCS and may also contact sidewalls of the first portion 220P1 and the second portion 220P2. Outer walls of the pair of buried insulating patterns 140 may be disposed on outer walls of the active pad hole APH, and/or may collectively have an annular horizontal cross-section with the pair of buried insulating patterns 140, the first portion 220P1, and the second portion 220P2. The pair of buried insulating patterns 140 may be formed using, but not be limited to, at least one of silicon nitride (SiN), silicon oxynitride (SiON), and a combination thereof.

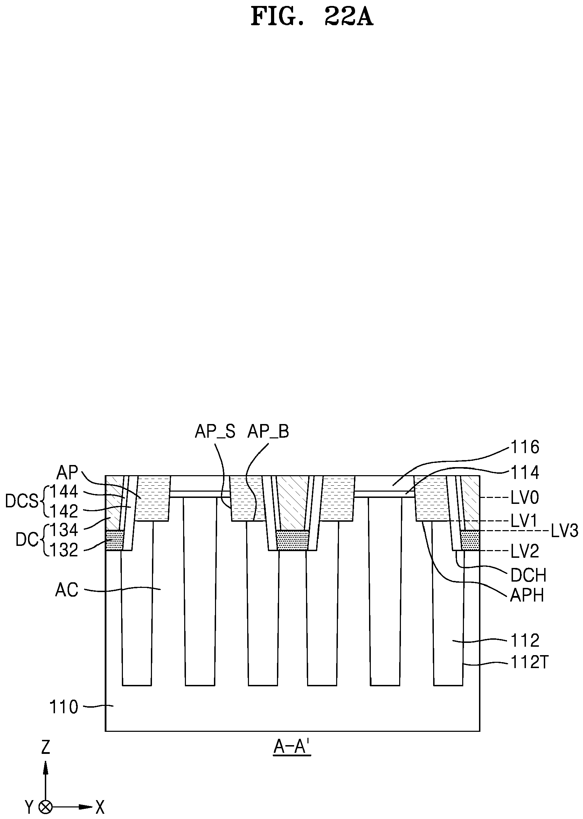

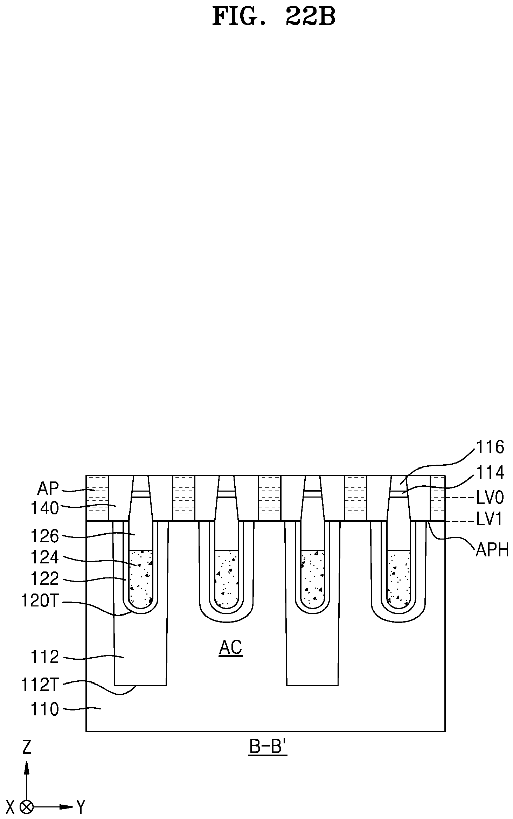

Referring to FIGS. 22A to 22C, the first part 220P1 and the second part 220P2 of the pad spacer 220 may be removed. In some embodiments, the process of removing the first portion 200P1 and the second portion 220P2 of the pad spacer 220 may be and/or may include an etching process using an etching condition having a relatively low etching rate for the pair of buried insulating patterns 140 and the bit line contact spacer DCS and another etching process using an etching condition having a relatively high etching rate for the pad spacer 220. For example, as the first part 220P1 and the second part 220P2 of the pad spacer 220 may be removed, the upper surface of the active region AC may be exposed on the inner wall of the active pad hole APH.

Subsequently, an active pad AP may be formed inside the active pad hole APH. In some embodiments, the active pad AP may be formed using doped polysilicon. In optional or additional embodiments, the active pad AP may be formed using, but not limited to, at least one of titanium (Ti), titanium nitride (TiN), tantalum (Ta), tantalum nitride (TaN), ruthenium (Ru), cobalt (Co), molybdenum (Mo), tungsten (W), tungsten nitride (WN), titanium silicium nitride (TiSiN), tungsten silicon nitride (WSiN), cobalt silicide (CoSi), nickel silicide (NiSi), and tungsten silicide (WSi).

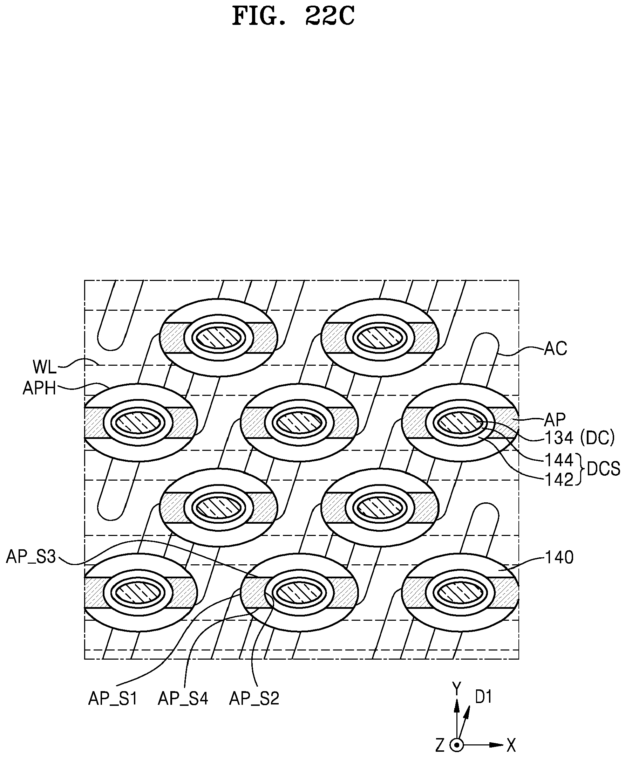

As shown in FIG. 22A, the active pad AP may have a sidewall AP_S extending vertically and/or substantially vertically and a bottom surface AP_B extending flat and/or substantially flat. Alternatively or additionally, the sidewall AP_S and the bottom surface AP_B may form a stepped portion and/or may be connected to each other. In an embodiment, as shown in FIG. 22C, from a plan view, the active pad AP may include a first side surface AP_S1 contacting the active region AC and having a curved surface, a second side surface AP_S2 contacting the bit line contact spacer DCS and having a curved surface, and a third side surface AP_S3 and a fourth side surface AP_S4 respectively contacting the pair of buried insulating patterns 140.

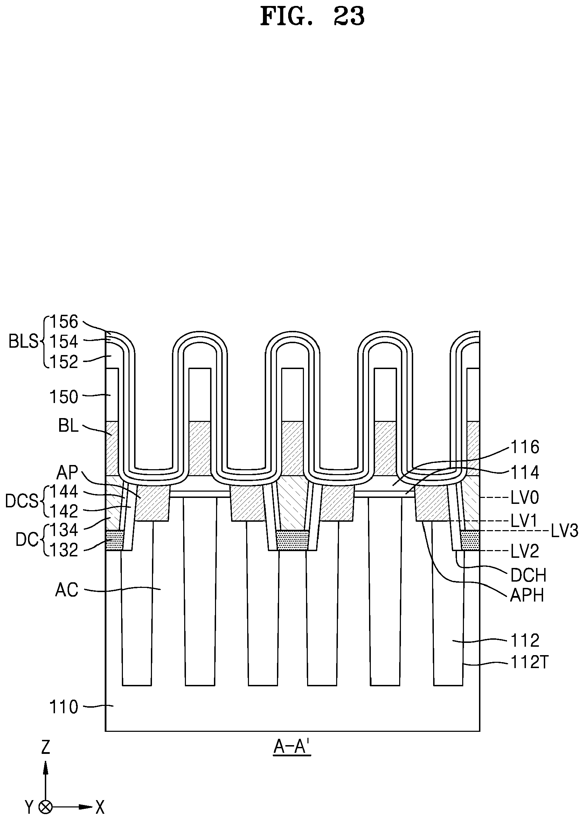

Referring to FIG. 23, a bit line conductive layer (not shown) and a bit line capping material layer (not shown) may be formed on the bit line contact DC and the active pad AP. Alternatively or additionally, a plurality of bit lines BL and a plurality of bit line capping layers 150 may be formed by patterning the bit line capping material layer and the bit line conductive layer.

In the patterning process for forming the plurality of bit lines BL and the plurality of bit line capping layers 150, a portion of the upper side of the bit line contact DC and a portion of the upper side of the active pad AP may be removed together. Accordingly, the upper surface of the active pad AP may be disposed at a vertical level lower than the upper surface of the bit line contact DC. Sidewalls of the bit line contacts DC (e.g., sidewalls of the second contact layer 134) may be surrounded by the second contact spacer layer 144 and may be substantially removed and/or unpatterned in the patterning process.

Subsequently, bit line spacers BLS may be formed on the plurality of bit lines BL and the plurality of bit line capping layers 150.

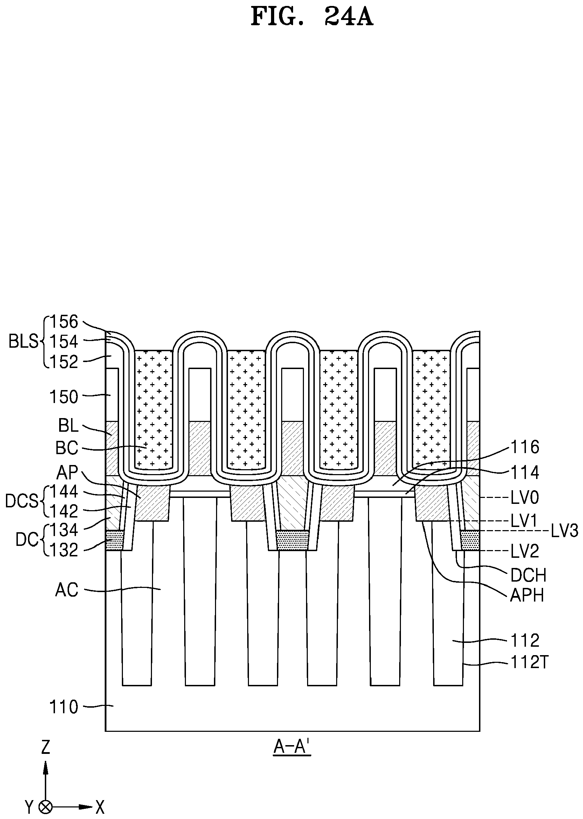

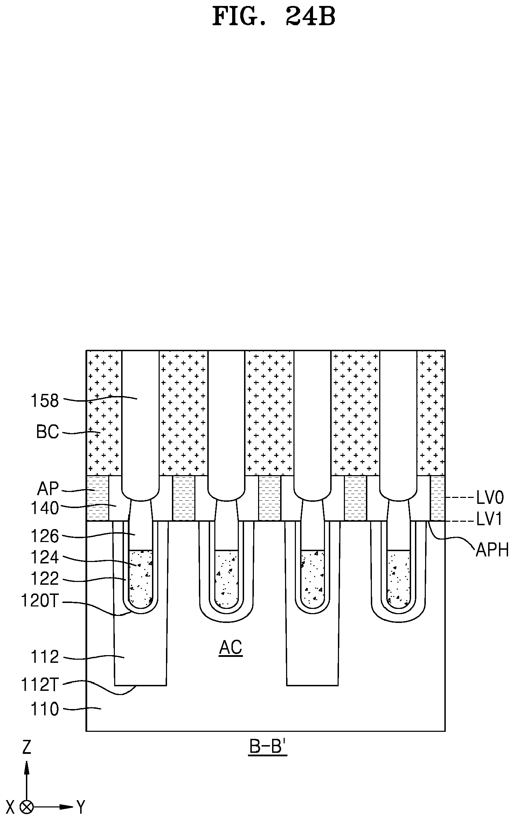

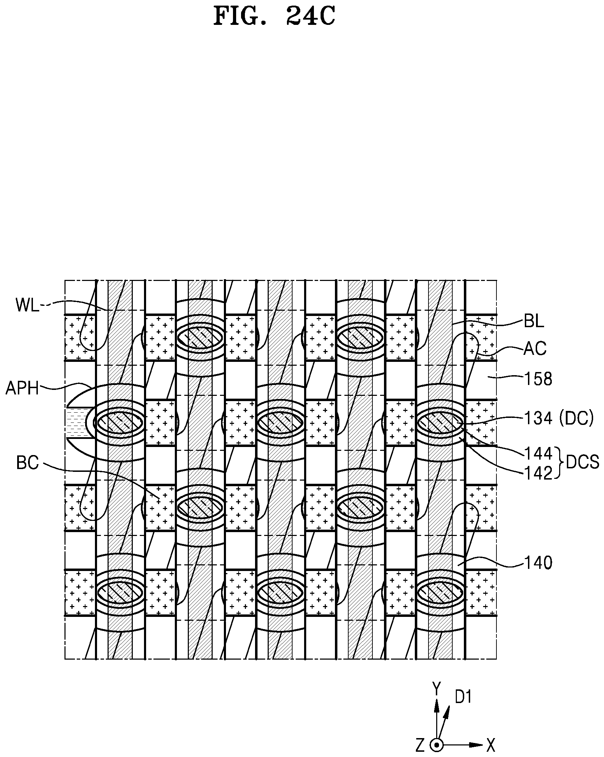

Referring to FIGS. 24A to 24C, the upper surface of the active pad AP may be exposed by removing a portion of the bit line spacer BLS disposed in the space between the plurality of bit lines BL. Alternatively or additionally, a plurality of buried contacts BC and an insulation fence 158 may be formed in the space between the plurality of bit lines BL. For example, the plurality of buried contacts BC may be disposed at positions vertically overlapping the active pad AP, and the insulation fence 158 may be disposed at a position vertically overlapping the word line WL between two adjacent bit lines BL.

In some embodiments, after forming a conductive layer (not shown) in a space between a plurality of bit lines BL, a plurality of buried contacts may be formed by removing a portion of the conductive layer. Alternatively or additionally, an insulation fence 158 may be formed in a region from which the conductive layer may be removed. In optional or additional embodiments, a plurality of insulation fences 158 spaced apart from each other in a second horizontal direction Y may be formed in a space between the plurality of bit lines BL. In such embodiments, a plurality of buried contacts BC may be formed by filling a conductive layer in the spaces between the plurality of bit lines BL and between the plurality of insulation fences 158.

In some embodiments, the plurality of buried contacts BC may be formed using doped polysilicon. In optional or additional embodiments, the plurality of buried contacts BC may be formed using, but not be limited to, at least one of titanium (Ti), titanium nitride (TiN), tantalum (Ta), tantalum nitride (TaN), ruthenium (Ru), cobalt (Co), molybdenum (Mo), tungsten (W), tungsten nitride (WN), titanium silicium nitride (TiSiN), tungsten silicon nitride (WSiN), cobalt silicide (CoSi), nickel silicide (NiSi), and tungsten silicide (WSi).

Referring again to FIGS. 1 to 6, the semiconductor device 100 may be completed by sequentially forming the landing pad LP and the insulating pattern 166 on the plurality of buried contacts BC and forming the capacitor structure CAP on the landing pad LP.

In related semiconductor devices, a bit line contact may be formed by patterning a bit line and then etching a side portion of the bit line contact disposed under the bit line to reduce the width of the bit line contact. However, as the spacing between bit lines is reduced, the difficulty of the bit line contact etching process may increase and/or may be relatively high. Alternatively or additionally, the difficulty of the process of forming a buried contact between an active region and a landing pad in a space between bit lines may also be relatively high.

According to embodiments, after the pad spacer 220 is formed in the active pad hole APH, the bit line contact DC may be formed in a damascene method, and after the pad spacer 220 is removed, the active pad AP may be formed. Accordingly, the difficulty of a process of patterning the bit line contact DC may be reduced. Alternatively or additionally, since a relatively large contact area may be secured between the active pad AP formed in the active pad hole APH and the active region AC, the semiconductor device 100 may have improved electrical performance when compared to related semiconductor devices. In one embodiment, the active pad may be a second active region of the plurality of active regions adjacent to the first active region, and the active pad may be disposed to face the bit line contact.

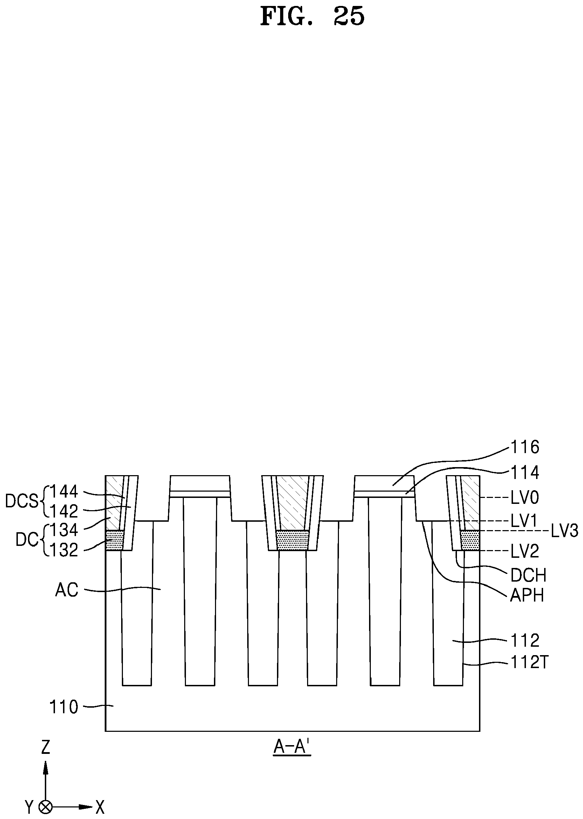

FIGS. 25 to 27 are cross-sectional views illustrating a method of manufacturing a semiconductor device 100, according to various embodiments.

The bit line contact DC may be formed in the active pad hole APH and the bit line contact hole DCH by performing the processes described with reference to FIGS. 14A to 21.

Referring to FIG. 25, the first portion 220P1 and the second portion 220P2 of the pad spacer 220 may be removed. In some embodiments, the process of removing the first portion 220P1 and the second portion 220P2 of the pad spacer 220 may be and/or may include an etching process using an etching condition having a relatively low etching rate for the pair of buried insulating patterns 140 and the bit line contact spacer DCS and another etching process using an etching condition having a relatively high etching rate for the pad spacer 220. For example, as the first part 220P1 and the second part 220P2 of the pad spacer 220 may be removed, the upper surface of the active region AC may be exposed on the inner wall of the active pad hole APH.

Referring to FIG. 26, a bit line conductive layer BLm and a bit line capping material layer 150m may be formed on the inner wall of the active pad hole APH on the bit line contact DC. The bit line conductive layer BLm may fill the inner wall of the active pad hole APH.

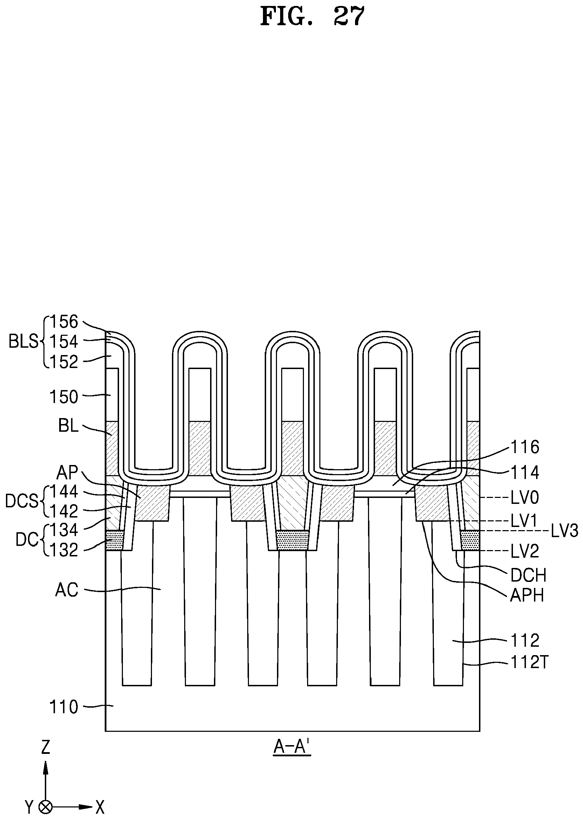

Referring to FIG. 27, a plurality of bit lines BL and a plurality of bit line capping layers 150 may be formed by patterning the bit line capping material layer 150m and the bit line conductive layer BLm. In the patterning process for forming a plurality of bit lines BL, a portion of the bit line conductive layer BLm formed on the inner wall of the active pad hole APH may be separated from the bit line BL. A portion of the bit line conductive layer BLm formed on the inner wall of the active pad hole APH may be referred to as an active pad AP. In such an embodiment, the active pad AP may be formed to include the same material as the material constituting the bit line BL.

Thereafter, the semiconductor device 100 may be completed by performing the processes described with reference to FIGS. 24A to 24C.

In optional or additional embodiments, before forming the bit line conductive layer BLm on the inner wall of the active pad hole APH, a conductive barrier layer may be selectively further formed on the inner wall of the active pad hole APH. In such an embodiment, the semiconductor device 100A described with reference to FIGS. 9 and 10 may be formed.

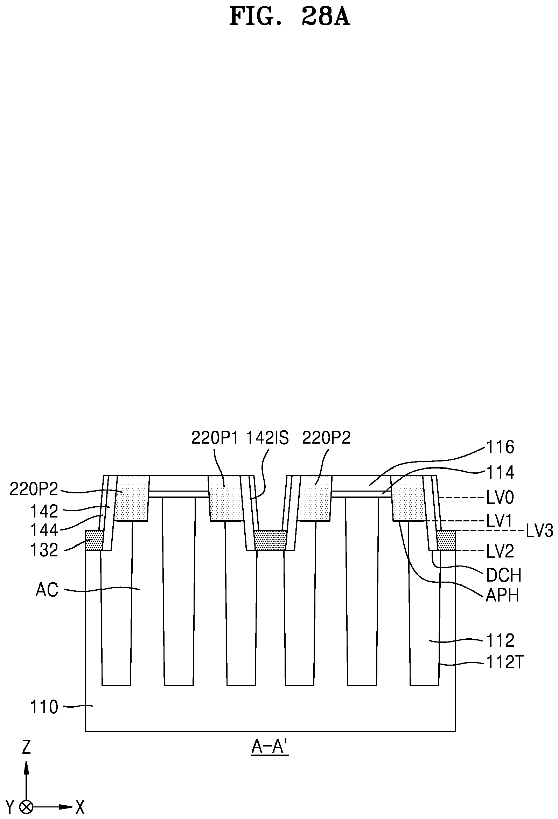

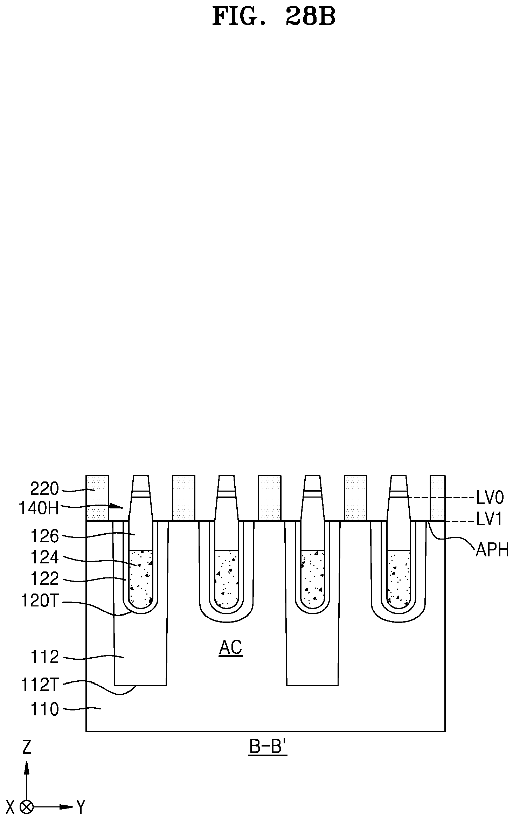

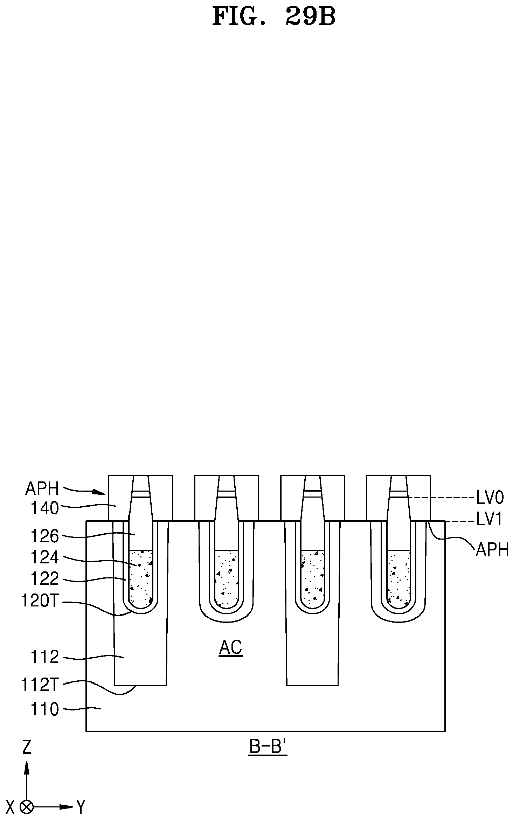

FIGS. 28A to 30 are cross-sectional views illustrating a method of manufacturing a semiconductor device 100, according to various embodiments. Referring to FIGS. 28A, 29B, and 30, cross-sectional views corresponding to cross-section A-A' of FIG. 2 are illustrated. Referring to FIGS. 28B and 29B, cross-sectional views corresponding to cross-section B-B' of FIG. 2 are illustrated.

A structure in which the first contact spacer layer 142 and the first contact layer 132 may be disposed in the bit line contact hole DCH may be formed by performing the processes described with reference to FIGS. 14A to 18B.

Referring to FIGS. 28A and 28B, the second contact spacer layer 144 may be formed on the sidewall of the bit line contact hole DCH (e.g., on the inner wall 142IS of the first contact spacer layer 142).

Thereafter, a portion of the pad spacer 220 may be removed by a trimming process to form a pair of recesses 140H.

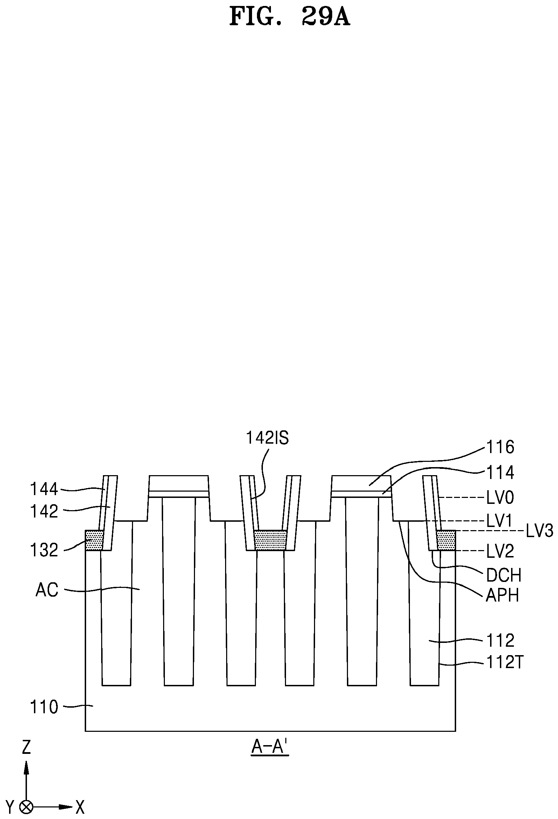

Referring to FIGS. 29A and 29B, a pair of buried insulating patterns 140 may be formed in the pair of recesses 140H. Thereafter, the first and second portions 220P1 and 220P2 of the pad spacer 220 may be removed to expose the upper surface of the active region AC disposed in the active pad hole APH.

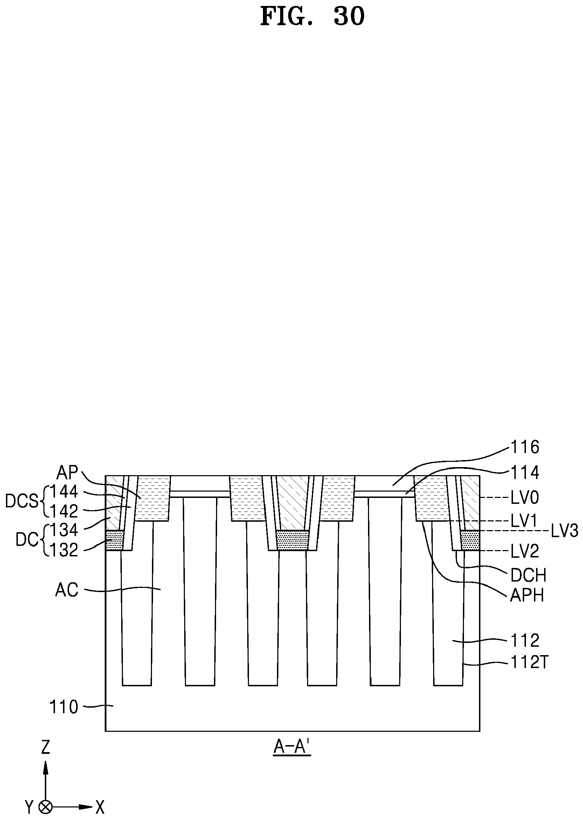

Referring to FIG. 30, the second contact layer 134 may be formed in the bit line contact hole DCH, and/or the active pad AP may be formed in the active pad hole APH. In some embodiments, the second contact layer 134 may be formed in the same process as the active pad AP. In such embodiments, the material of the second contact layer 134 may be substantially similar and/or the same as the material of the active pad AP.

Thereafter, the semiconductor device 100 may be completely formed by performing the processes described with reference to FIGS. 23 to 24C.

While the present disclosure has been shown and described with reference to embodiments thereof, it may be understood that various changes in form and details may be made therein without departing from the scope of the following claims.

## Claims

1. A semiconductor device, comprising:
a substrate comprising a plurality of active regions defined by device isolation layers;
a plurality of bit lines extending in a first horizontal direction on the substrate;
a bit line contact between a first active region of the plurality of active regions and a first bit line of the plurality of bit lines on the first active region, the bit line contact comprising a first contact layer and a second contact layer on the first contact layer; and
an active pad on a second active region of the plurality of active regions adjacent to the first active region, the active pad disposed to face the bit line contact.

2. The semiconductor device of claim 1, further comprising:
a bit line contact spacer surrounding at least a portion of the bit line contact,
the bit line contact spacer comprising:
a first contact spacer layer on an inner wall of a bit line contact hole extending into the substrate; and
a second contact spacer layer on an inner sidewall of the first contact spacer layer on the inner wall of the bit line contact hole.

3. The semiconductor device of claim 2, wherein the active pad contacts an outer wall of the first contact spacer layer.

4. The semiconductor device of claim 2 or 3, wherein, from a plan view, the active pad comprises:
a first side surface contacting the first active region and having a first curved surface; and
a second side surface contacting the first contact spacer layer and having a second curved surface,
wherein the first side surface of the active pad forms at least a first portion of concentric circles,
wherein the second side of the active pad forms at least a second portion of the concentric circles.

5. The semiconductor device of claim 4, wherein:
the first side surface of the active pad and a bottom surface of the active pad form a first stepped portion, and
the second side surface of the active pad and the bottom surface of the active pad form a second stepped portion.

6. The semiconductor device of any one of claims 2 to 5, wherein:
a sidewall of the first contact layer is at least partially surrounded by the first contact spacer layer,
a bottom surface of the first contact layer contacts a top surface of the first active region, and
the second contact layer is at least partially surrounded by the second contact spacer layer on an upper surface of the first contact layer.

7. The semiconductor device of any one of claims 2 to 6, further comprising:
bit line spacers disposed on both sidewalls of the plurality of bit lines,
wherein the bit line spacers at least partially cover a first upper surface of the second contact layer and a second upper surface of the second contact spacer layer, and
wherein the bit line spacers do not extend into the bit line contact hole.

8. The semiconductor device of any one preceding claim, wherein:
the first contact layer has a first width in a second horizontal direction perpendicular to the first horizontal direction,
the second contact layer has a second width in the second horizontal direction, and
the second width is less than the first width.

9. The semiconductor device of any one preceding claim, wherein a first level of a first bottom surface of the second contact layer is lower than a second level of a second bottom surface of the active pad.

10. The semiconductor device of any one preceding claim,
wherein the active pad comprises at least one of doped polysilicon, titanium (Ti), titanium nitride (TiN), tantalum (Ta), tantalum nitride (TaN), ruthenium (Ru), cobalt (Co), molybdenum (Mo), tungsten (W), tungsten nitride (WN), titanium silicium nitride (TiSiN), tungsten silicon nitride (WSiN), cobalt silicide (CoSi), nickel silicide (NiSi), and tungsten silicide (WSi), and
the first contact layer and the second contact layer comprises at least one of Ti, TiN, Ta, TaN, Ru, Co, Mo, W, WN, TiSiN, WSiN, CoSi, NiSi, and WSi.

11. A semiconductor device, comprising:
a substrate comprising a plurality of active regions defined by device isolation layers;
a plurality of bit lines extending in a first horizontal direction on the substrate;
a bit line contact between a first active region of the plurality of active regions and a first bit line of the plurality of bit lines on the first active region, the bit line contact comprising a first contact layer and a second contact layer on the first contact layer;
a bit line contact spacer surrounding at least a first portion of the bit line contact; and
an active pad disposed in an active pad hole extending into a second active region of the plurality of active regions adjacent to the first active region, the active pad surrounding at least a second portion of the bit line contact spacer.

12. The semiconductor device of claim 11, wherein:
the active pad hole comprises a stepped portion at a boundary between a sidewall of the active pad hole and a bottom portion of the active pad hole, and
the active pad contacts the second active region at the sidewall of the active pad hole and the bottom portion of the active pad hole.

13. The semiconductor device of claim 11 or 12, wherein the bit line contact spacer comprises:
a first contact spacer layer on a first inner wall of a bit line contact hole extending into the substrate, and
a second contact spacer layer on the first inner wall of the bit line contact hole and on a second inner wall of the first contact spacer layer.

14. The semiconductor device of claim 13, wherein:
the active pad hole forms a concentric circle with the bit line contact hole, and
the active pad contacts an outer wall of the first contact spacer layer.

15. The semiconductor device of claim 13 or 14, wherein:
a sidewall of the first contact layer is at least partially surrounded by the first contact spacer layer,
a bottom surface of the first contact layer contacts a top surface of the first active region, and
the second contact layer is at least partially surrounded by the second contact spacer layer on an upper surface of the first contact layer.
